# EUROPEAN PATENT APPLICATION

(11) **EP 4 301 109 A1**
(43) Date of publication of application: **03.01.2024**
(21) Application number: 23171250.6
(22) Date of filing: 03.05.2023
(51) Int. Cl.: H10B 43/27, H10B 43/10, H10B 43/50

(54) **THREE-DIMENSIONAL SEMICONDUCTOR MEMORY DEVICES AND ELECTRONIC SYSTEMS INCLUDING THE SAME**

(30) Priority: 27.06.2022 KR 20220078345
(71) Applicant: Samsung Electronics Co., Ltd., Suwon-si, Gyeonggi-do 16677 (KR)
(72) Inventor: KIM, Jiwon, 16677 Suwon-si (KR); KIM, Dohyung, 16677 Suwon-si (KR); KIM, Jiyoung, 16677 Suwon-si (KR); SUNG, Sukkang, 16677 Suwon-si (KR)
(74) Representative: Marks & Clerk LLP

(57) **Abstract**

A three-dimensional semiconductor memory device includes a first substrate, a peripheral circuit structure on the first substrate, and a cell array structure on the peripheral circuit structure. The cell array structure includes a stacked structure including gate electrodes extending in a first direction, a source structure on the stacked structure, and a second substrate in contact with the source structure. The source structure includes a first source conductive pattern between the second substrate and the stacked structure and a second source conductive pattern on the first source conductive pattern. The second source conductive pattern includes a first source part between the first source conductive pattern and the second substrate, a source connection part passing through the second substrate and extending in the first direction, and a second source part on the second substrate and connected to the first source part through the source connection part.

## Description

### BACKGROUND OF THE INVENTION

Inventive concepts relate to three-dimensional semiconductor memory devices, methods of manufacturing the same, and electronic systems including the same, and more particularly, to three-dimensional semiconductor memory devices including peripheral circuit structures and cell array structures coupled to each other through bonding pads, and methods of manufacturing the same, and electronic systems including the same.

A need may arise to have a semiconductor device capable of storing a large amount of data in an electronic system which needs data storage. Semiconductor devices have been highly integrated to meet high performance and low manufacturing cost, which are desired by customers. Integration of typical two-dimensional or planar semiconductor devices may primarily be determined by the area occupied by a unit memory cell, and thus it may be greatly influenced by the level of technology used to form fine patterns. However, an expense of processing equipment used to increase pattern fineness may set a practical limitation on increasing the integration of the two-dimensional or planar semiconductor devices. Therefore, three-dimensional semiconductor memory devices having three-dimensionally arranged memory cells have been proposed.

### SUMMARY

An object of some inventive concepts may include providing three-dimensional semiconductor memory devices capable of simplifying processes and methods of manufacturing the same.

An object of some inventive concepts may include providing three-dimensional semiconductor memory devices having improved electrical characteristics and reliability, and methods of manufacturing the same.

Problems to be addressed by some inventive concepts disclosed herein are not limited to problems mentioned above, and other problems not mentioned may be clearly understood by those skilled in the art from the following description.

A three-dimensional semiconductor memory device according to some embodiments of inventive concepts may include a first substrate, a peripheral circuit structure on the first substrate, and a cell array structure on the peripheral circuit structure. The cell array structure may include a stacked structure including gate electrodes extending in a first direction, a source structure on the stacked structure, and a second substrate in contact with the source structure. The source structure may include a first source conductive pattern between the second substrate and the stacked structure, and a second source conductive pattern on the first source conductive pattern. The second source conductive pattern may include a first source part between the first source conductive pattern and the second substrate, a source connection part passing through the second substrate and extending in the first direction, and a second source part on the second substrate and connected to the first source part through the source connection part.

A three-dimensional semiconductor memory device according to some embodiments of inventive concepts may include a first substrate, a peripheral circuit structure on a first substrate, and a cell array structure on the peripheral circuit structure. The cell array structure may include a stacked structure including conductive patterns extending in a first direction, a source structure on the stacked structure, vertical channel structures connected to the source structure through the stacked structure, and a second substrate in contact with the source structure. The source structure may include a first source conductive pattern between the second substrate and the stacked structure and a second source conductive pattern on the first source conductive pattern. The second source conductive pattern may include a first source part between the first source conductive pattern and the second substrate, a source connection part passing through the second substrate, and a second source part on the second substrate and connected to the first source part through the source connection part. The stacked structure may include a first stacked structure and a second stacked structure. The cell array structure may further include a separation pattern between the first stacked structure and the second stacked structure, with the cell array structure extending in the first direction. The source connection part may be between the separation pattern and a vertical channel structure closest to the separation pattern among the vertical channel structures.

An electronic system according to some embodiments of inventive concepts may include a three-dimensional semiconductor memory device and a controller. The three-dimensional semiconductor memory device may include a first substrate, a peripheral circuit structure on the first substrate, and a cell array structure on the peripheral circuit structure, with the cell array structure including a cell array region and a cell array contact region. The cell array structure may include a stacked structure including gate electrodes extending in a first direction, a source structure on the stacked structure, and a second substrate in contact with the source structure. The source structure may include a first source conductive pattern between the second substrate and the stacked structure, and a second source conductive pattern on the first source conductive pattern. The second source conductive pattern may include a first source part between the first source conductive pattern and the second substrate, a source connection part passing through the second substrate and extending in the first direction, and a second source part on the second substrate and connected to the first source part through the source connection part. The controller may be electrically connected to the three-dimensional semiconductor memory device through an input/output pad, wherein the controller is configured to control the three-dimensional semiconductor memory device.

At least some of the above and other features of the invention are set out in the claims.

### BRIEF DESCRIPTION OF THE DRAWINGS

Example embodiments will be more clearly understood from the following description taken in conjunction with the accompanying drawings. The accompanying drawings represent non-limiting, example embodiments as described herein.
FIG. 1 is a diagram schematically illustrating an electronic system including a three-dimensional semiconductor memory device according to some embodiments of inventive concepts.
FIGS. 2A and 2B are perspective views schematically illustrating an electronic system including a three-dimensional semiconductor memory device according to some embodiments of inventive concepts.
FIGS. 3 and 4 are cross-sectional views illustrating a semiconductor package including a three-dimensional semiconductor memory device according to some embodiments of inventive concepts, and correspond to cross-sectional views taken along lines I-I' and II-II' of FIG. 2B, respectively.
FIG. 5A is a plan view illustrating a three-dimensional semiconductor memory device according to some embodiments of inventive concepts.
FIGS. 5B and 5C are cross-sectional views illustrating a three-dimensional semiconductor memory device according to some embodiments of inventive concepts, and correspond to cross-sections taken along lines I-I' and II-II' in FIG. 5A, respectively.
FIG. 5D is an enlarged view of part "Q" of FIG. 5C.
FIG. 5E is an enlarged view of part "A" of FIG. 5D.
FIG. 6A is an enlarged view of part "A" of FIG. 5D according to some embodiments of inventive concepts.
FIGS. 6B and 6C are enlarged views of a part "Q" of FIG. 5C according to some embodiments of inventive concepts.
FIGS. 7A to 7E are plan views illustrating a source structure according to some embodiments of inventive concepts.
FIGS. 8A and 12A to 15A are views illustrating a method of manufacturing a three-dimensional semiconductor memory device according to some embodiments of inventive concepts and are cross-sectional views taken along line I-I' of FIG. 5A.
FIGS. 8B, 12B to 15B are views illustrating a method of manufacturing a three-dimensional semiconductor memory device according to some embodiments of inventive concepts and are cross-sectional views taken along line II-II' of FIG. 5A.
FIGS. 9A to 11A are cross-sectional views illustrating a method of manufacturing a three-dimensional semiconductor memory device according to some embodiments of inventive concepts and are cross-sectional views taken along line III-III' of FIG. 5A.
FIGS. 9B to 11B are views illustrating a method of manufacturing a three-dimensional semiconductor memory device according to some embodiments of inventive concepts, and are cross-sectional views taken along line IV-IV' of FIG. 5A.

### DETAILED DESCRIPTION

Reference will now be made in detail to embodiments, examples of which are illustrated in the accompanying drawings, wherein like reference numerals refer to like elements throughout and the sizes of each of the elements may be exaggerated for clarity and conveniences of explanation.

Spatially relative terms, such as "beneath," "below," "lower," "above," "upper," "vertical," and the like, may be used herein for ease of description to describe one element's or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the term "below" can encompass both an orientation of above and below. The device may be otherwise oriented (rotated 90 degrees or at other orientations), and the spatially relative descriptors used herein may be interpreted accordingly.

It will be understood that, although the terms first, second, etc. may be used herein to describe various elements, these elements should not be limited by these terms. These terms are only used to distinguish one element from another element. Thus, a first element discussed below could be termed a second element without departing from the scope of the present inventive concepts.

It will also be understood that when an element is referred to as being "on" or "connected to" or "in contact with" another element, it can be directly on or directly connected to or directly in contact with the other element, or intervening elements may be present. In contrast, when an element is referred to as being "directly on" or "directly connected to" or "directly in contact with" another element, there are no intervening elements present.

Hereinafter, three-dimensional semiconductor memory devices, methods of manufacturing the same, and electronic systems including the same according to some embodiments of inventive concepts will be described in detail with reference to the drawings.

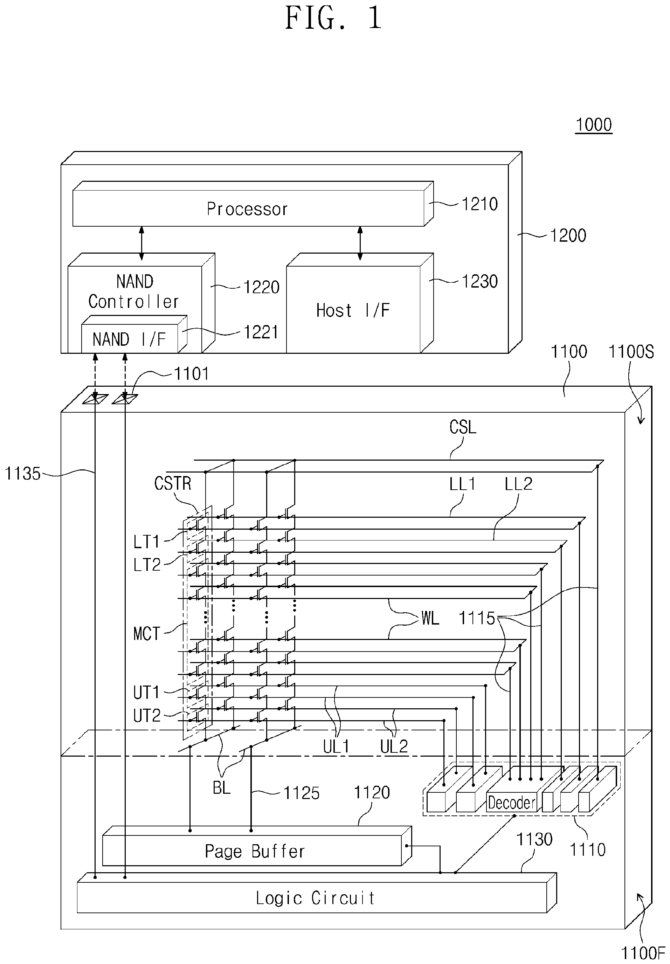

FIG. 1 is a diagram schematically illustrating an electronic system including a three-dimensional semiconductor memory device according to some embodiments of inventive concepts.

Referring to FIG. 1, an electronic system 1000 according to some embodiments of inventive concepts may include a three-dimensional semiconductor memory device 1100 and a controller 1200 electrically connected to the three-dimensional semiconductor memory device 1100. The electronic system 1000 may be a storage device including one or a plurality of three-dimensional semiconductor memory devices 1100 or an electronic device including a storage device. For example, the electronic system 1000 may be a solid-state drive (SSD) device, a universal serial bus (USB) device, a computing system, a medical device, or a communication device including one or a plurality of three-dimensional semiconductor memory devices 1100.

The three-dimensional semiconductor memory device 1100 may be a nonvolatile memory device, for example, a three-dimensional NAND flash memory device to be described later. The three-dimensional semiconductor memory device 1100 may include a first region 1100F and a second region 1100S on the first region 1100F. However, unlike the drawings, the first region 1100F may be disposed next to the second region 1100S. The first region 1100F may be a peripheral circuit region including a decoder circuit 1110, a page buffer 1120, and a logic circuit 1130. The second region 1100S may be a memory cell region including bit lines BL, a common source line CSL, word lines WL, first lines LL1 and LL2, second lines UL1 and UL2, and memory cell strings CSTR between the bit lines BL and the common source line CSL.

In the second region 1 100S, each of the memory cell strings CSTR may include first transistors LT1 and LT2 adjacent to the common source line CSL, second transistors UT1 and UT2 adjacent to the bit lines BL, and a plurality of memory cell transistors MCT disposed between the first transistors LT1 and LT2 and the second transistors UT1 and UT2. The number of the first transistors LT1 and LT2 and the number of the second transistors UT1 and UT2 may be variously modified according to different embodiments. The memory cell strings CSTR may be positioned between the common source line CSL and the first region 1100F.

For example, the second transistors UT1 and UT2 may include a string select transistor, and the first transistors LT1 and LT2 may include a ground select transistor. The first lines LL1 and LL2 may be gate electrodes of the first transistors LT1 and LT2. The word lines WL may be gate electrodes of the memory cell transistors MCT, and the second lines UL1 and UL2 may be gate electrodes of the second transistors UT1 and UT2.

For example, the first transistors LT1 and LT2 may include a first erase control transistor LT1 and a ground select transistor LT2 connected in series. For example, the second transistors UT1 and UT2 may include a string select transistor UT1 and a second erase control transistor UT2 connected in series. At least one of the first erase control transistor LT1 and the second erase control transistor UT2 may be used in an erase operation to erase data stored in the memory cell transistors MCT using a gate induce drain leakage (GIDL) phenomenon.

The common source line CSL, the first lines LL1 and LL2, the word lines WL, and the second lines UL1 and UL2 may be electrically connected to the decoder circuit 1110 through first connection wirings 1115 extending from the first region 1100F to the second region 1100S. The bit lines BL may be electrically connected to the page buffer 1120 through second connection wirings 1125 extending from the first region 1100F to the second region 1 100S.

In the first region 1100F, the decoder circuit 1110 and the page buffer 1120 may perform a control operation on at least one selected memory cell transistor among the plurality of memory cell transistors MCT. The decoder circuit 1110 and the page buffer 1120 may be controlled by the logic circuit 1130. The three-dimensional semiconductor memory device 1100 may communicate with the controller 1200 through an input/output pad 1101 electrically connected to the logic circuit 1130. The input/output pad 1101 may be electrically connected to the logic circuit 1130 through an input/output connection line 1135 extending from the first region 1100F to the second region 1100S.

The controller 1200 may include a processor 1210, a NAND controller 1220, and a host interface 1230. In some embodiments, the electronic system 1000 may include a plurality of three-dimensional semiconductor memory devices 1100. In this case, the controller 1200 may control the plurality of three-dimensional semiconductor memory devices 1100.

The processor 1210 may control an overall operation of the electronic system 1000 including the controller 1200. The processor 1210 may operate using a certain firmware, and may access the three-dimensional semiconductor memory device 1100 by controlling the NAND controller 1220. A control command to control the three-dimensional semiconductor memory device 1100, to control data to be written to the memory cell transistors MCT of the three-dimensional semiconductor memory device 1100, and to control data to be read from the memory cell transistors MCT of the three-dimensional semiconductor memory device 1100 may be transmitted through a NAND interface 1221. The host interface 1230 may provide a communication function between the electronic system 1000 and an external host. When receiving a control command from an external host through the host interface 1230, the processor 1210 may control the three-dimensional semiconductor memory device 1100 in response to the control command.

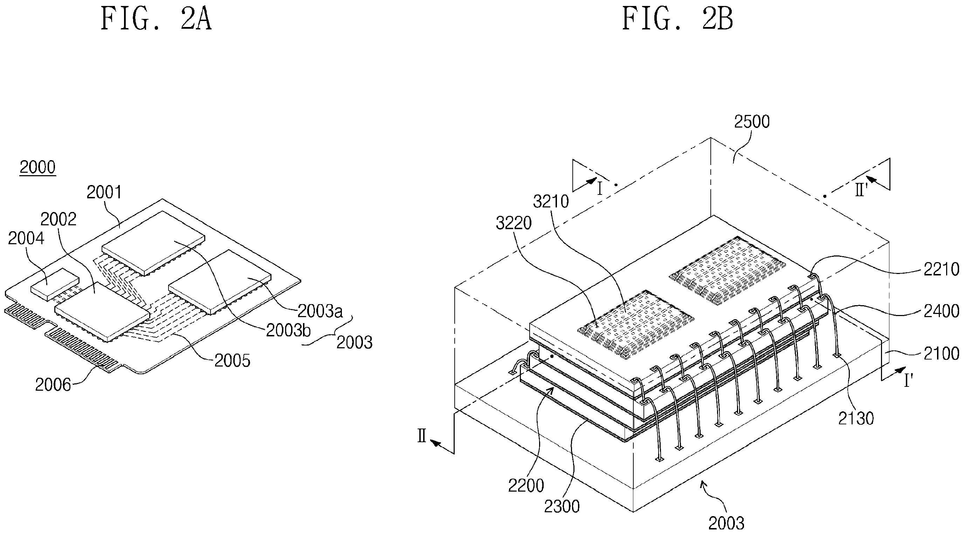

FIGS. 2A and 2B are perspective views schematically illustrating an electronic system including a three-dimensional semiconductor memory device according to some embodiments of inventive concepts.

Referring to FIG. 2A, an electronic system 2000 according to some embodiments of inventive concepts may include a main board 2001, a controller 2002 mounted on the main board 2001, one or more semiconductor packages 2003, and a DRAM 2004. The semiconductor package 2003 and the DRAM 2004 may be connected to the controller 2002 by wiring patterns 2005 provided on the main board 2001.

The main board 2001 may include a connector 2006 including a plurality of pins coupled to an external host. The number and arrangement of the plurality of pins in the connector 2006 may vary according to a communication interface between the electronic system 2000 and an external host. The electronic system 2000 may communicate with the external host through one or more interfaces, for example, universal serial bus (USB), peripheral component interconnect express (PIC-Express), serial advanced technology attachment (SATA), and/or M-PHY for universal flash storage (UFS). For example, the electronic system 2000 may operate with power supplied through the connector 2006 from the external host. The electronic system 2000 may further include a power management integrated circuit (PMIC) that distributes the power supplied from the external host to the controller 2002 and the semiconductor package 2003.

The controller 2002 may write data to the semiconductor package 2003, may read data from the semiconductor package 2003, or may increase an operating speed of the electronic system 2000.

The DRAM 2004 may be a buffer memory that reduces a difference in speed between the external host and the semiconductor package 2003 that serves as a data storage space. The DRAM 2004 included in the electronic system 2000 may operate as a cache memory, and may provide a space for temporary data storage in a control operation of the semiconductor package 2003. When the DRAM 2004 is included in the electronic system 2000, the controller 2002 may include not only a NAND controller to control the semiconductor package 2003, but also a DRAM controller to control the DRAM 2004.

The semiconductor package 2003 may include a first semiconductor package 2003a and a second semiconductor package 2003b that are spaced apart from each other. Each of the first and second semiconductor packages 2003a and 2003b may include a plurality of semiconductor chips 2200 as shown in FIG. 2B. Each of the first and second semiconductor packages 2003a and 2003b may include a package substrate 2100, semiconductor chips 2200 on the package substrate 2100, adhesive layers 2300 on bottom surfaces of the semiconductor chips 2200, connection structures 2400 that electrically connect the semiconductor chips 2200 to the package substrate 2100, and a molding layer 2500 covering the semiconductor chips 2200 and the connection structures 2400, on the package substrate 2100.

The package substrate 2100 may be a printed circuit board including package upper pads 2130. Each of the semiconductor chips 2200 may include input/output pads 2210. Each of the input/output pads 2210 may correspond to the input/output pad 1101 of FIG. 1. Each of the semiconductor chips 2200 may include gate stacked structures 3210 and memory channel structures 3220. Each of the semiconductor chips 2200 may include a three-dimensional semiconductor memory device as described below.

The connection structures 2400 may be, for example, bonding wires that electrically connect the input/output pads 2210 to the package upper pads 2130. Therefore, in each of the first and second semiconductor packages 2003a and 2003b, the semiconductor chips 2200 may be electrically connected to each other in a wire bonding manner, and may be electrically connected to the package upper pads 2130 of the package substrate 2100. In some embodiments, in each of the first and second semiconductor packages 2003a and 2003b, the semiconductor chips 2200 may be electrically connected to each other using through-silicon vias instead of the connection structures 2400 in the wire bonding manner.

Unlike the drawings, the controller 2002 and the semiconductor chips 2200 may be included in one package. The controller 2002 and the semiconductor chips 2200 may be mounted on a separate interposer substrate other than the main board 2001, and may be connected to each other through wirings provided in the interposer substrate.

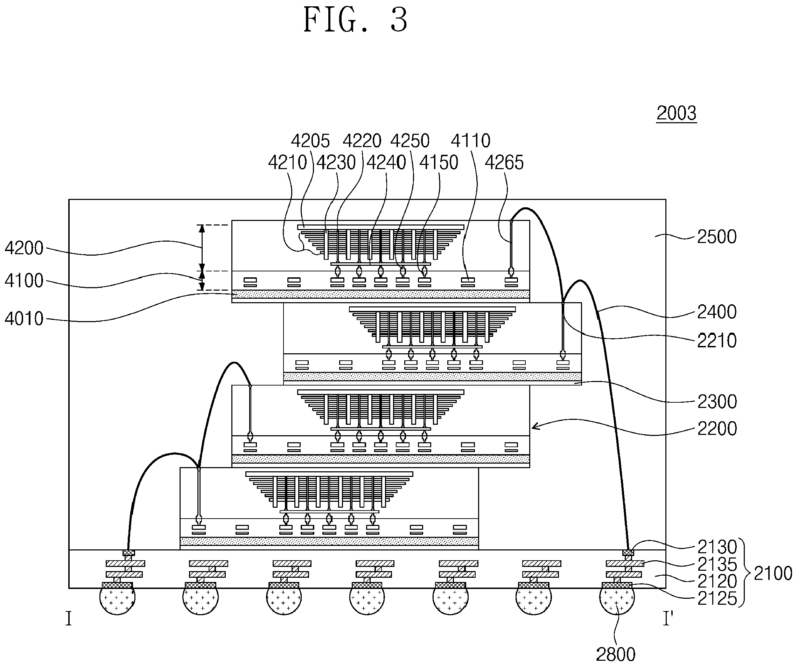

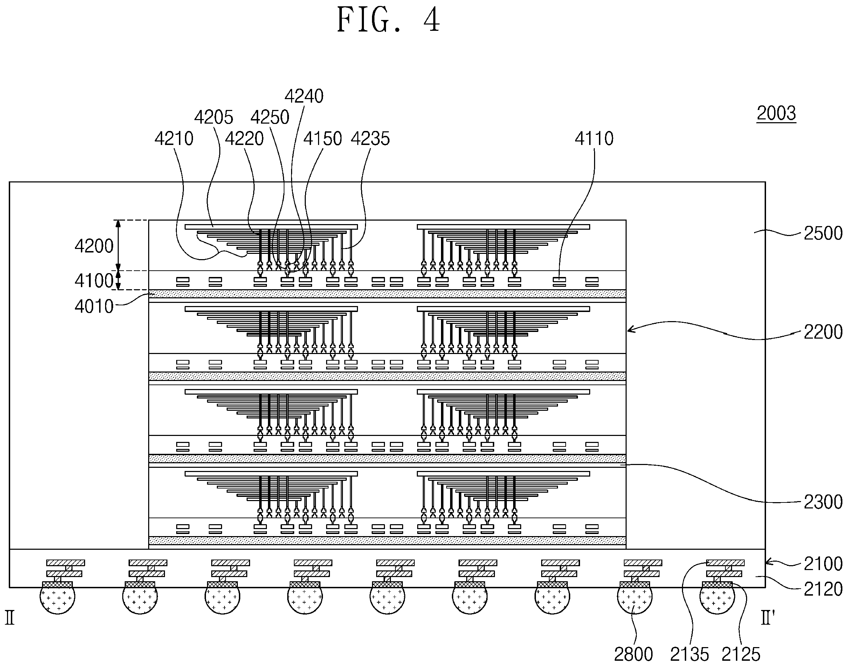

FIGS. 3 and 4 are cross-sectional views illustrating a semiconductor package including a three-dimensional semiconductor memory device according to some embodiments of inventive concepts, and corresponding to cross-sectional views taken along lines I-I' and II-II' of FIG. 2B, respectively.

Referring to FIGS. 3 and 4, a semiconductor package 2003 may include a package substrate 2100, a plurality of semiconductor chips 2200 on the package substrate 2100, and a molding layer 2500 covering the package substrate 2100 and the semiconductor chips 2200.

As shown in FIG. 3, the package substrate 2100 may include a package substrate body 2120, upper pads 2130 disposed on or exposed through an upper surface of the package substrate body 2120, lower pads 2125 disposed on or exposed through the lower surface of the package substrate body 2120, and internal wirings 2135 electrically connecting the upper pads 2130 and the lower pads 2125 in the package substrate body 2120. The lower pads 2125 may be connected to the wiring patterns 2005 of the main board 2001 of the electronic system 2000 illustrated in FIG. 2A through conductive connectors 2800.

Referring to FIGS. 3 and 4, sidewalls of the semiconductor chips 2200 may be not aligned with each other in one direction as shown in FIG. 3, and sidewalls of the semiconductor chips 2200 may be aligned with each other in another direction as shown in FIG 4. The semiconductor chips 2200 may be electrically connected to each other by connection structures 2400 in a form of wire bonding. Each of the semiconductor chips 2200 may include substantially the same components.

Each of the semiconductor chips 2200 may include a semiconductor substrate 4010, a first structure 4100 on the semiconductor substrate 4010, and a second structure 4200 on the first structure 4100. The second structure 4200 may be coupled to the first structure 4100 in a wafer bonding manner.

The first structure 4100 may include peripheral circuit wirings 4110 and first bonding pads 4150. The second structure 4200 may include a common source line 4205, a gate stacked structure 4210 between the common source line 4205 and the first structure 4100, memory channel structures 4220 and separation structures 4230 passing through the gate stacked structure 4210, and second bonding pads 4250 electrically connected to the memory channel structures 4220 and the word lines (WL of FIG. 1) of the gate stacked structure 4210, respectively. For example, the second bonding pads 4250 may be electrically connected to the memory channel structures 4220 and the word lines (WL of FIG. 1), respectively, through gate connection wirings 4235 (shown in Fig. 4) electrically connected to bit lines 4240 and the word lines (WL in FIG. 1) electrically connected to the memory channel structures 4220. The first bonding pads 4150 of the first structure 4100 and the second bonding pads 4250 of the second structure 4200 may be coupled and may be in contact with each other. Coupled portions of the first bonding pads 4150 and the second bonding pads 4250 may include, for example, copper (Cu).

Each of the semiconductor chips 2200 may further include an input/output pad 2210 and an input/output connection wiring 4265 under the input/output pad 2210. The input/output connection wiring 4265 may be electrically connected to some of the second bonding pads 4250 and some of the peripheral circuit lines 4110.

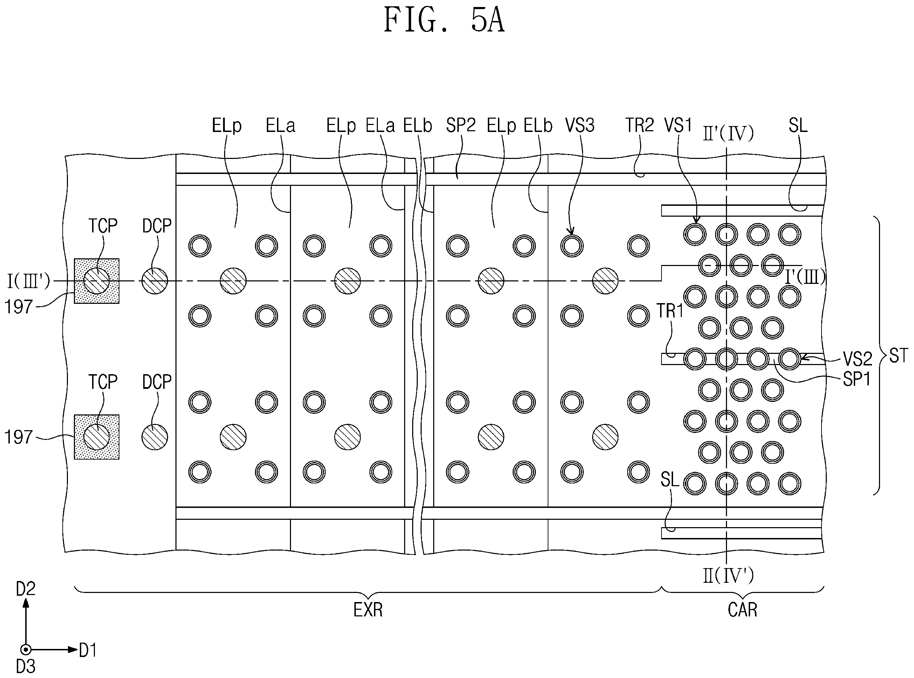

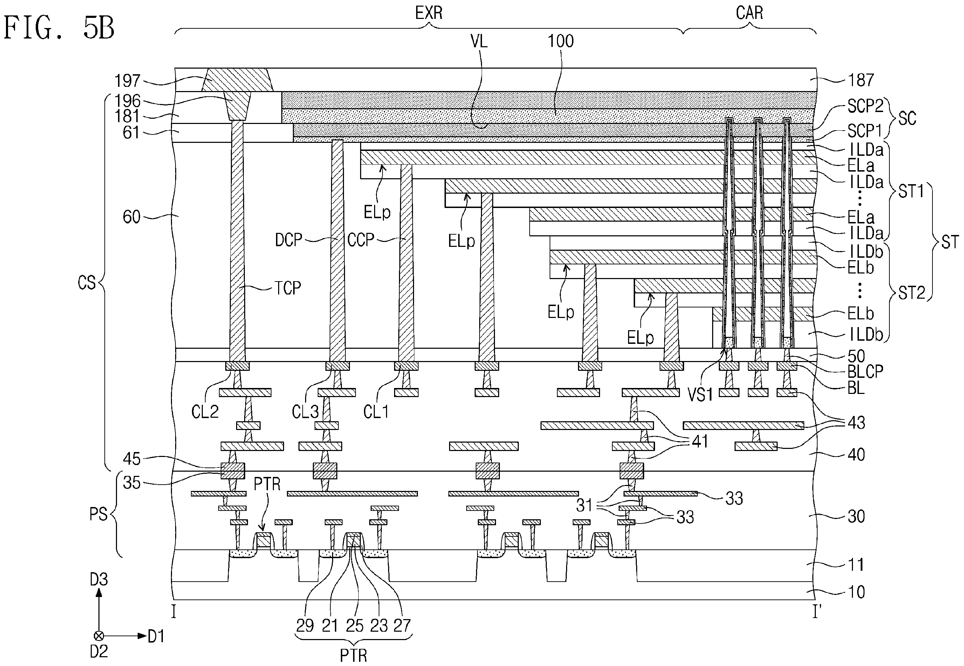

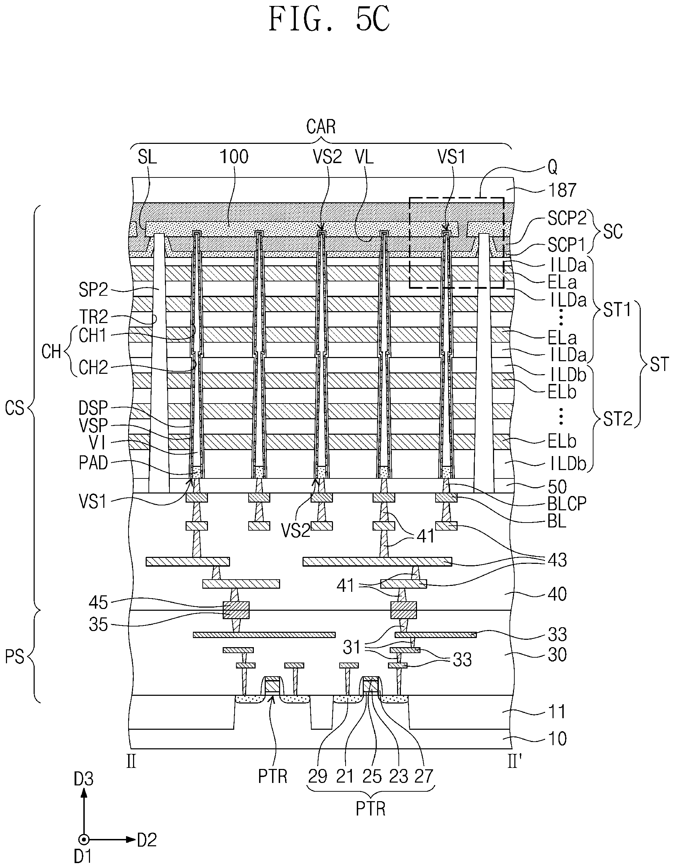

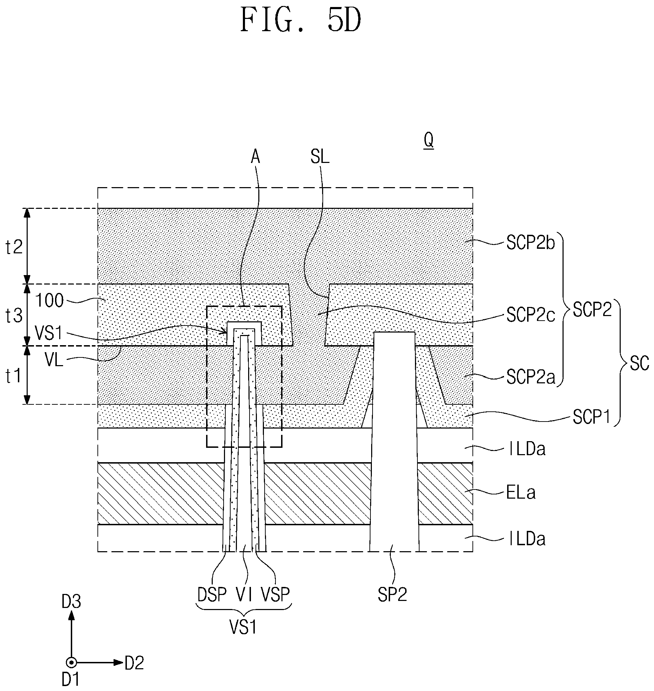

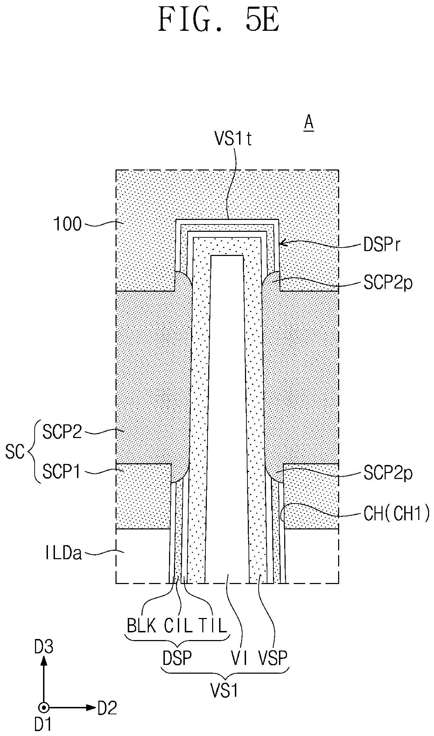

FIG. 5A is a plan view illustrating a three-dimensional semiconductor memory device according to some embodiments. FIGS. 5B and 5C are cross-sectional views illustrating a three-dimensional semiconductor memory device according to some embodiments of inventive concepts, and FIGS. 5B and 5C correspond to cross-sections taken along lines I-I' and II-II' in FIG. 5A, respectively. FIG. 5D is an enlarged view of part "Q" of FIG. 5C. FIG. 5E is an enlarged view of part "A" of FIG. 5D.

Referring to FIGS. 5A to 5E, a three-dimensional semiconductor memory device according to some embodiments of inventive concepts may include a first substrate 10, a peripheral circuit structure PS on the first substrate 10, and a cell array structure CS on the peripheral circuit structure PS. The first substrate 10, the peripheral circuit structure PS, and the cell array structure CS may correspond to the semiconductor substrate 4010, the first structure 4100 on the semiconductor substrate 4010, and the second structure 4200 on the first structure 4100 of FIGS. 3 and 4, respectively.

When the cell array structure CS is disposed on the peripheral circuit structure PS, the cell array structure CS and the peripheral circuit structure PS may be combined with each other, and thus a cell capacity per unit area of the three-dimensional semiconductor memory device according to some embodiments of inventive concepts may be increased. In addition, the peripheral circuit structure PS and the cell array structure CS may be respectively manufactured separately and then may be combined with each other, and thus damage to peripheral transistors PTR due to various heat treatment processes may be reduced, thereby improving electrical characteristics and reliability of the three-dimensional semiconductor memory device according to some embodiments of inventive concepts.

The first substrate 10 may be, for example, a silicon substrate, a silicon-germanium substrate, a germanium substrate, or a single crystal epitaxial layer grown on a monocrystalline silicon substrate. The first substrate 10 may have an upper surface that is parallel to a first direction D1 and a second direction D2 intersecting the first direction D1 and is perpendicular to a third direction D3. The first to third directions D1, D2, and D3 may be, for example, directions orthogonal to each other. A device isolation layer 11 may be provided in the first substrate 10. The device isolation layer 11 may define an active region of the first substrate 10.

A peripheral circuit structure may include peripheral transistors PTR, peripheral contact plugs 31, peripheral circuit wirings 33, first bonding pads 35, and a first interlayer insulating layer 30 may be provided on the first substrate 10. Peripheral circuit wirings 33 may be electrically connected to the peripheral transistors PTR through the peripheral contact plugs 31. First bonding pads 35 may be electrically connected to the peripheral circuit wirings 33. First interlayer insulating layer 30 may surround the peripheral transistors PTR, the peripheral contact plugs 31, the peripheral circuit wirings 33, and the first bonding pads 35. The peripheral transistors PTR may be provided on the active region of the first substrate 10. The peripheral circuit wirings 33 may correspond to the peripheral circuit wirings 4110 of FIGS. 3 and 4, and the first bonding pads 35 may correspond to the first bonding pads 4150 of FIGS. 3 and 4.

For example, a width of each of the peripheral contact plugs 31 in the first direction D1 or the second direction D2 may increase in the third direction D3. Stated in other words, a width of a contact plug 31 (in directions D1 and D2) may increase with increasing distance from substrate 10 (in direction D3). The peripheral contact plugs 31 and the peripheral circuit wirings 33 may include a conductive material such as metal.

The peripheral transistors PTR may include, for example, a decoder circuit (1110 in FIG. 1), a page buffer (1120 in FIG. 1), and a logic circuit (1130 in FIG. 1). For example, each of the peripheral transistors PTR may include a peripheral gate insulating layer 21, a peripheral gate electrode 23, a peripheral capping pattern 25, a peripheral gate spacer 27, and peripheral source/drain regions 29. The peripheral gate insulating layer 21 may be provided between the peripheral gate electrode 23 and the first substrate 10. The peripheral capping pattern 25 may be provided on the peripheral gate electrode 23. The peripheral gate spacer 27 may cover sidewalls of the peripheral gate insulating layer 21, the peripheral gate electrode 23, and the peripheral capping pattern 25. The peripheral source/drain regions 29 may be provided in the first substrate 10 adjacent to both sides of the peripheral gate electrode 23. The peripheral circuit wirings 33 and the first bonding pads 35 may be electrically connected to respective elements of peripheral transistors PTR through peripheral contact plugs 31. Each of the peripheral transistors PTR may be, for example, an NMOS (n-channel Metal Oxide Semiconductor) transistor or a PMOS (p-channel Metal Oxide Semiconductor) transistor.

The first interlayer insulating layer 30 may be provided on the first substrate 10. The first interlayer insulating layer 30 may cover the peripheral transistors PTR, the peripheral contact plugs 31, and the peripheral circuit wirings 33 on the first substrate 10. The first interlayer insulating layer 30 may include a plurality of insulating layers having a multilayer structure. For example, the first interlayer insulating layer 30 may include silicon oxide, silicon nitride, silicon oxynitride, and/or a low-k material. The first interlayer insulating layer 30 may not cover upper surfaces of the first bonding pads 35. An upper surface of the first interlayer insulating layer 30 may be substantially coplanar with the upper surfaces of the first bonding pads 35.

The cell array structure CS may include second bonding pads 45, bit lines BL, and a stacked structure ST, and a second substrate 100, and the cell array structure CS may be provided on the peripheral circuit structure PS. The cell array structure CS may include a cell array region CAR and a cell array contact region EXR. The cell array contact region EXR may extend in the first direction D1 (or a direction opposite to the first direction D1) from the cell array region CAR.

The second bonding pads 45, the bit lines BL, the stacked structure ST, and the second substrate 100 may correspond to the second bonding pads 4250, the bit lines 4240, the gate stacked structure 4210, and the common source line 4205 of FIGS. 3 and 4, respectively.

The second bonding pads 45 may be in electrical contact with respective first bonding pads 35 of the peripheral circuit structure PS, and second bonding pads 45 may be electrically coupled with respective connection contact plugs 41 and connection circuit wirings 43. Second interlayer insulating layer 40 may be provided on the first interlayer insulating layer 30 surrounding the second bonding pads 45, the connection contact plugs 41, and the connection circuit wirings 43.

The second interlayer insulating layer 40 may include a plurality of insulating layers having a multilayer structure. For example, the second interlayer insulating layer 40 may include silicon oxide, silicon nitride, silicon oxynitride, and/or a low-k material.

For example, a width of the connection contact plugs 41 in the first direction D1 or the second direction D2 may decrease in the third direction D3. Stated in other words, a width of each connection contact plug 41 (in directions D1 and D2) may decrease with increasing distance from substrate 10 (in direction D3); or a width of each connection contact plug 41 (in directions D1 and D2) may increase with increasing distance from interlayer insulating layers 50/60 and/or from second substrate 100. The connection contact plugs 41 and the connection circuit wirings 43 may include a conductive material such as metal.

The second interlayer insulating layer 40 may not cover lower surfaces of the second bonding pads 45. A lower surface of the second interlayer insulating layer 40 may be substantially coplanar with the lower surfaces of the second bonding pads 45. The lower surface of each of the second bonding pads 45 may be in direct contact with the upper surface of each of the first bonding pads 35. The first and second bonding pads 35 and 45 may include a metal such as copper (Cu), tungsten (W), aluminum (Al), nickel (Ni), or tin (Sn). For example, the first and second bonding pads 35 and 45 may include copper (Cu). The first and second bonding pads 35 and 45 may form an integral shape without an interface therebetween. Although sidewalls of the first and second bonding pads 35 and 45 are shown to be aligned side by side, inventive concepts are not limited thereto, and in a plan view (e.g., in a plane defined by directions D1 and D2), the sidewalls of the first and second bonding pads 35 and 45 may be spaced apart from each other.

The bit lines BL and first to third conductive lines CL1, CL2, and CL3 in contact with the connection contact plugs 41 may be provided on the second interlayer insulating layer 40. Each of the bit lines BL and the first to third conductive lines CL1, CL2, and CL3 may extend, for example, in the second direction D2 and may be spaced apart from each other in the first direction D1. The bit lines BL and the first to third conductive lines CL1, CL2, and CL3 may include a conductive material such as a metal.

A third interlayer insulating layer 50 may be provided on the second interlayer insulating layer 40. A fourth interlayer insulating layer 60 and the stacked structure ST surrounded by the fourth interlayer insulating layer 60 may be provided on the third interlayer insulating layer 50. The third and fourth insulating layers 50 and 60 may include a plurality of insulating layers having a multilayer structure. For example, each of the third and fourth insulating layers 50 and 60 may include silicon oxide, silicon nitride, silicon oxynitride, and/or a low-k material.

Bit line contact plugs BLCP may be provided in the third interlayer insulating layer 50. The bit line contact plugs BLCP may extend in the third direction D3 and may connect the bit lines BL to first vertical channel structures VS1 to be described later.

Cell contact plugs CCP, a source contact plug DCP, and a through contact plug TCP passing through the third interlayer insulating layer 50 and the fourth interlayer insulating layer 60 may be provided. The cell contact plugs CCP may extend in the third direction D3 and may connect the first conductive lines CL1 to gate electrodes ELa and ELb of the stacked structure ST to be described later. Each of the cell contact plugs CCP may pass through any one or more of interlayer insulating layers ILDa and/or ILDb of the stacked structure ST to be described later. The through contact plug TCP may extend in the third direction D3 and may connect the second conductive line CL2 to a back-side conductive pattern 197 to be described later. The source contact plug DCP may extend in the third direction D3 and may connect the second substrate 100 to the third conductive line CL3.

The bit line contact plugs BLCP, the cell contact plugs CCP, and the through contact plug TCP may be spaced apart from each other in the first direction D1. A width of each of the bit line contact plugs BLCP, the cell contact plugs CCP, the source contact plug DCP, and the through contact plug TCP in the first direction D1 and/or in the second direction may decrease in the third direction D3. Stated in other words, a width of each of the bit line contact plugs BLCP, the cell contact plugs CCP, the source contact plug DCP, and the through contact plug TCP (in directions D1 and D2) may decrease with increasing distance from substrate 10 (in direction D3); or a width of each of the bit line contact plugs BLCP, the cell contact plugs CCP, the source contact plug DCP, and the through contact plug TCP (in directions D1 and D2) may increase with increasing distance from interlayer insulating layers 50/60 and/or from second substrate 100. The bit line contact plugs BLCP, the cell contact plugs CCP, the source contact plug DCP, and the through contact plug TCP may include a metal material such as tungsten.

The stacked structure ST may be provided on the third interlayer insulating layer 50. The stacked structure ST may be surrounded by the fourth interlayer insulating layer 60. A lower surface of the stacked structure ST (i.e., a surface in contact with the third interlayer insulating layer 50) may be substantially coplanar with a lower surface of the fourth interlayer insulating layer 60.

The stacked structure ST may be provided in plurality. The plurality of stacked structures ST may extend in the first direction D1 and may be spaced apart from each other in the second direction D2 in a plan view of FIG. 5A (e.g., in a plane defined by directions D1 and D2). Hereinafter, a single stacked structure ST will be described for convenience of description, but the following description may be equally applied to other stacked structures ST.

The stacked structure ST may include an upper stacked structure ST1 and a lower stacked structure ST2. The upper stacked structure ST1 may include first interlayer insulating layers ILDa and first gate electrodes ELa that are alternately stacked, and the lower stacked structure ST2 may include second interlayer insulating layers ILDb and second gate electrodes ELb that are alternately stacked.

The lower stacked structure ST2 may be provided between the upper stacked structure ST1 and the first substrate 10. In detail, the lower stacked structure ST2 may be provided on a lower surface of the bottommost one of the first interlayer insulating layers ILDa of the upper stacked structure ST1. A topmost one of the second interlayer insulating layers ILDb of the lower stacked structure ST2 and a lowermost one of the first interlayer insulating layers ILDa of the upper stacked structure ST1 may be in contact with each other, but inventive concepts are not limited thereto, and a single insulating layer may be provided between the uppermost of the second gate electrodes ELb of the lower stacked structure ST2 and the first gate electrodes ELa of the upper stacked structure ST1.

The first and second gate electrodes ELa and ELb may include at least one selected from, for example, a doped semiconductor (e.g., doped silicon, etc.), a metal (e.g., tungsten, copper, aluminum, etc.), a conductive metal nitride (e.g., nitride titanium, tantalum nitride, etc.) or a transition metal (e.g., titanium, tantalum, etc.). The first and second interlayer insulating layers ILDa and ILDb may include silicon oxide, silicon nitride, silicon oxynitride, and/or a low-k material. For example, the first and second interlayer insulating layers ILDa and ILDb may include high-density plasma oxide (HDP oxide) or tetraethylorthosilicate (TEOS).

In the cell array contact region EXR, a thickness of each of the upper and lower stacked structures ST1 and ST2 in the third direction D3 may decrease as moving away from the outermost one of the first vertical channel structures VS1 to be described later. That is, each of the upper and lower stacked structures ST1 and ST2 may have a step structure in the first direction D1.

In detail, a length in the first direction D1 of each of the first gate electrodes ELa of the upper stacked structure ST1 and the second gate electrodes ELb of the lower stacked structure ST2 may increase as moving away from the first substrate 10. Sidewalls of the first and second gate electrodes ELa and ELb may be spaced apart from each other at regular intervals in the first direction D1 in a plan view of FIG. 5A (e.g., in a plane defined by directions D1 and D2). The lowermost one of the second gate electrodes ELb of the lower stacked structure ST2 may have the smallest length in the first direction D1, and the uppermost one of the first gate electrodes ELa of the upper stacked structure ST1 may have the greatest length in the first direction D1.

The first and second gate electrodes ELa and ELb may include pad parts ELp in the cell array contact region EXR. The pad parts ELp may be disposed at different positions horizontally and vertically. The pad parts ELp may have a step structure in the first direction D1. The above-described cell contact plugs CCP may pass through one of the first and second interlayer insulating layers ILDa and ILDb to be in contact with the pad parts ELp of the first and second gate electrodes ELa and ELb.

The first and second interlayer insulating layers ILDa and ILDb may be provided between the first and second gate electrodes ELa and ELb; and a sidewall of one of the first and second gate electrodes ELa and ELb in contact with an upper portion of one of the first and second interlayer insulating layers ILDa and ILDb may be aligned with a sidewall of the corresponding one of the first and second interlayer insulating layer ILDa and ILDb. That is, like the first and second gate electrodes ELa and ELb, a length in the first direction D1 of each of the first and second interlayer insulating layers ILDa and ILDb may increase as a distance of each of the first and second interlayer insulating layers ILDa and ILDb from the first substrate 10 increases. The lowermost one of the second interlayer insulating layers ILDb may have a greater thickness in the third direction D3 than other second interlayer insulating layers ILDb, and the uppermost one of the first interlayer insulating layers ILDa may have a smaller thickness in the third direction D3 than other first interlayer insulating layers IDLa, but inventive concepts are not limited thereto.

In the cell array region CAR, the first vertical channel structures VS1 and second vertical channel structures VS2 may be provided in vertical channel holes CH passing through the stacked structure ST in the third direction D3. The first vertical channel structures VS1 may correspond to the memory channel structures 4220 of FIGS. 3 and 4.

In the cell array contact region EXR, third vertical channel structures VS3 may be provided in vertical channel holes CH passing through at least a portion of the stacked structure ST and the fourth interlayer insulating layer 60 in the third direction D3.

The vertical channel holes CH may include first vertical channel holes CH1 and second vertical channel holes CH2 connected to the first vertical channel holes CH1. A width of each of the first and second vertical channel holes CH1 and CH2 in the first direction D1 or the second direction D2 may decrease as a distance from the first substrate 10 increases. The first and second vertical channel holes CH1 and CH2 may have different diameters at a boundary where the first and second vertical channel holes CH1 and CH2 are connected to each other. In detail, an upper diameter of each of the second vertical channel holes CH2 may be smaller than a lower diameter of each of the first vertical channel holes CH1. Each of the first and second vertical channel holes CH1 and CH2 may have a step difference at the boundary thereof. However, inventive concepts are not limited thereto, unlike the structure illustrated in FIGS. 5A to 5B, the first to third vertical channel structures VS1, VS2, and VS3 may be provided in three or more vertical channel holes CH each having a step difference at two or more boundaries, and the first to third vertical channel structures VS1, VS2, and VS3 may be provided in the vertical channel holes CH having flat sidewalls without a step difference.

As shown in FIGS. 5C, 5D, and 5E, each of the first to third vertical channel structures VS1, VS2, and VS3 may include a conductive pad PAD adjacent to the third interlayer insulating layer 50, a data storage pattern DSP conformally covering inner sidewalls of each of the first and second vertical channel holes CH1 and CH2, a vertical semiconductor pattern VSP conformally covering sidewalls of the data storage pattern DSP, and a buried insulating pattern VI filling an inner space of each of the first and second vertical channel holes CH1 and CH2 surrounded by the vertical semiconductor pattern VSP and the conductive pad PAD. The vertical semiconductor pattern VSP may be surrounded by the data storage pattern DSP. A lower surface of each of the first to third vertical channel structures VS1, VS2, and VS3 may have, for example, a circular, oval, or bar shape.

The vertical semiconductor pattern VSP may be provided between the data storage pattern DSP and the buried insulating pattern VI and between the data storage pattern DSP and the conductive pad PAD. The vertical semiconductor pattern VSP may have a pipe shape with a closed top or a macaroni shape. The data storage pattern DSP may have an open top pipe shape or a macaroni shape. The vertical semiconductor pattern VSP may include, for example, a semiconductor material doped with an impurity, an intrinsic semiconductor material in an undoped state, or a polycrystalline semiconductor material. The conductive pad PAD may include, for example, a semiconductor material doped with impurities or a conductive material.

In a plan view of FIG. 5A (e.g., in a plane defined by directions D1 and D2), a first trench TR1 and a second trench TR2 extending in the first direction D1 and crossing the stacked structure ST may be provided. The first trench TR1 may be provided in the cell array region CAR, and the second trench TR2 may extend from the cell array region CAR toward the cell array contact region EXR. A width of each of the first and second trenches TR1 and TR2 in the first direction D1 or the second direction D2 may decrease as a distance thereof from the first substrate 10 increases.

A first separation pattern SP1 and a second separation pattern SP2 may be provided to fill an inside of each of the first and second trenches TR1 and TR2, respectively. The first and second separation patterns SP1 and SP2 may correspond to the separation structures 4230 of FIGS. 3 and 4. A length of the second separation pattern SP2 in the first direction D1 may be greater than a length of the first separation pattern SP1 in the first direction D1. Sidewalls of the first and second separation patterns SP1 and SP2 may be in contact with at least a portion of the first and second gate electrodes ELa and ELb and the first and second interlayer insulating layers ILDa and ILDb of the stacked structure ST. The first and second separation patterns SP1 and SP2 may include, for example, an oxide such as silicon oxide.

A lower surface of the second separation pattern SP2 may be substantially coplanar with a lower surface of the third interlayer insulating layer 50 (i.e., the upper surface of the second interlayer insulating layer 40) and upper surfaces of the bit lines BL and the first and second conductive lines CL1 and CL2.

When the stacked structure ST is provided in plurality, a second separation pattern SP2 may be provided between the stacked structures ST arranged in the second direction D2. That is, the stacked structures ST may be spaced apart from each other in the second direction D2 with the second separation pattern SP2 therebetween.

The second substrate 100 may be provided on the stacked structure ST. That is, the stacked structure ST may be provided on a first surface of the second substrate 100. The second substrate 100 may be connected to a lower portion of each of the first vertical channel structures VS1 and the second vertical channel structures VS2. The second substrate 100 may include a monocrystalline semiconductor material, for example, a single crystalline silicon layer, but alternatively may include a polycrystalline silicon layer. A source structure SC may be provided between the second substrate 100 and the stacked structure ST. The second substrate 100 and the source structure SC may extend in the first direction D1 and the second direction D2 parallel to the upper surface of the first substrate 10 (or the upper surface of the stacked structure ST). The second substrate 100 may have a flat plate shape extending parallel to the upper surface of the first substrate 10.

The source structure SC may include a first source conductive pattern SCP1 between the stacked structure ST and the second substrate 100 and a second source conductive pattern SCP2 on the first source conductive pattern SCP1. The first source conductive pattern SCP1 may be provided between the second source conductive pattern SCP2 and the uppermost one of the first interlayer insulating layers ILDa of the upper stacked structure ST1. The second source conductive pattern SCP2 may be in direct contact with the first source conductive pattern SCP1. A thickness of the second source conductive pattern SCP2 in the third direction D3 may be greater than a thickness of the first source conductive pattern SCP1 in the third direction D3. The source structure SC may include a semiconductor material doped with impurities. The source structure SC may include, for example, a semiconductor material doped with impurities of the same conductivity type as that of the second substrate 100. For example, an impurity concentration of the second source conductive pattern SCP2 may be greater than an impurity concentration of the first source conductive pattern SCP1 and an impurity concentration of the second substrate 100.

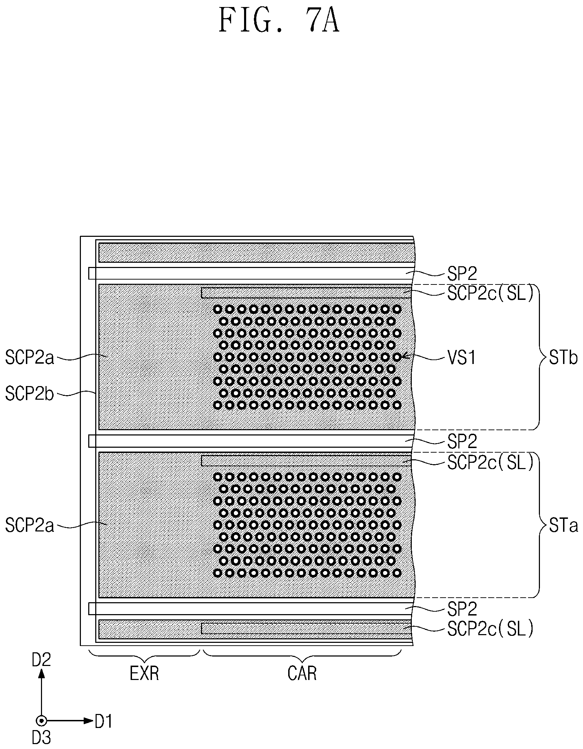

Referring to FIGS. 5D and 7A, the second source conductive pattern SCP2 may include a first source part SCP2a between the first source conductive pattern SCP1 and the second substrate 100, a source connection part SCP2c passing through the second substrate 100 and extending in the first direction D1, and a second source part SCP2b provided on the second substrate 100 and connected to the first source part SCP2a through the source connection part SCP2c. The source connection part SCP2c may be provided in a slit SL passing through the second substrate 100. An upper width of the slit SL may be greater than a lower width thereof. The first source part SCP2a may fill a void region VL that is a space connected to the slit SL. The slit SL may have a bar or line shape extending in the first direction D1 along the first trench TR1 and/or the second trench TR2 as shown in FIG. 5A. A planar shape of the slit SL corresponds to a shape of the source connection part SCP2c, and will be described in more detail below with reference to FIGS. 7A to 7E. The first source part SCP2a may extend toward the second substrate 100 to be in contact with a sidewall of the second separation pattern SP2. The vertical semiconductor patterns VSP of the first vertical channel structures VS1 may be connected to the first source part SCP2a.

A thickness t2 of the second source part SCP2b may be greater than a thickness t1 of the first source part SCP2a. The thickness t1 of the first source part SCP2a may be smaller than a thickness t3 of the second substrate 100 and smaller than the thickness t2 of the second source part SCP2b. In another embodiment, the thickness t2 of the second source part SCP2b may be smaller than the thickness t3 of the second substrate 100.

FIG. 5E illustrates one of the first vertical channel structures VS1 including the data storage pattern DSP, the vertical semiconductor pattern VSP, the buried insulating pattern VI, and a lower data storage pattern DSPr. Hereinafter, the single vertical channel hole CH and the first vertical channel structure VS1 will be described for convenience of description, but the following description may be equally applied to other vertical channel holes CH and the first vertical channel structures VS1.

An upper surface VS1t of the first vertical channel structure VS1 may be in contact with the second substrate 100. The upper surface VS1t of the first vertical channel structure VS1 may correspond to an upper surface of the lower data storage pattern DSPr. The data storage pattern DSP may include a blocking insulating layer BLK, a charge storage layer CIL, and a tunneling insulating layer TIL sequentially stacked on a sidewall of the vertical channel hole CH. The blocking insulating layer BLK may be adjacent to the stacked structure ST or the source structure SC, and the tunneling insulating layer TIL may be adjacent to the vertical semiconductor pattern VSP. The charge storage layer CIL may be interposed between the blocking insulating layer BLK and the tunneling insulating layer TIL. The blocking insulating layer BLK, the charge storage layer CIL, and the tunneling insulating layer TIL may extend in the third direction D3 between the stacked structure ST and the vertical semiconductor pattern VSP. Due to the Fowler-Nordheim tunneling phenomenon induced by a voltage difference between the vertical semiconductor pattern VSP and the first and second gate electrodes ELa and ELb, the data storage pattern DSP may store and/or change data. For example, the blocking insulating layer BLK and the tunneling insulating layer TIL may include silicon oxide, and the charge storage layer CIL may include silicon nitride or silicon oxynitride.

The second source conductive pattern SCP2 of the source structure SC may be in contact with the vertical semiconductor pattern VSP, and the first source conductive pattern SCP1 may be spaced apart from the vertical semiconductor pattern VSP with the data storage pattern DSP interposed therebetween. The first source conductive pattern SCP1 may be spaced apart from the buried insulating pattern VI with the vertical semiconductor pattern VSP interposed therebetween.

In detail, the second source conductive pattern SCP2 may include protrusions SCP2p protruding in the third direction D3 and in an opposite direction to the third direction D3. One surface of each of the protrusions SCP2p in contact with the data storage pattern DSP or the lower data storage pattern DSPr may have a curved shape.

Referring back to FIGS. 5A and 5B, a fifth interlayer insulating layer 61, a sixth interlayer insulating layer 181, and a seventh interlayer insulating layer 187 may be sequentially provided on the fourth interlayer insulating layer 60. The fifth interlayer insulating layer 61 and the sixth interlayer insulating layer 181 may be at the same level as the source structure SC and the second substrate 100, respectively. In detail, the first source part SCP2a and the first source conductive pattern SCP1 may be at the same level as the fifth interlayer insulating layer 61, and the second source part SCP2b and the second substrate 100 may be at the same level as the sixth interlayer insulating layer 181. A through via 196 connected to the through contact plug TCP may be provided in the sixth interlayer insulating layer 181. A back-side conductive pattern 197 connected to the through via 196 may be provided in the seventh interlayer insulating layer 187.

The back-side conductive pattern 197 may have a lower surface width smaller than an upper surface width. The back-side conductive pattern 197 may be electrically connected to the second conductive line CL2 through the through via 196 and the through contact plug TCP, and furthermore, may be electrically connected to at least one of the peripheral transistors PTR of the peripheral circuit structure PS. The back-side conductive pattern 197 may correspond to one of the input/output pads 1101 of FIG. 1 or the input/output pads 2210 of FIGS. 3 and 4. Alternatively, the back-side conductive pattern 197 may be a part of the back-side metal wirings. The back-side conductive pattern 197 may include a material different from that of the through via 196 and the through contact plug TCP. For example, the back-side conductive pattern 197 may include aluminum, and the through via 196 and the through contact plug TCP may include at least one of tungsten, titanium, or tantalum.

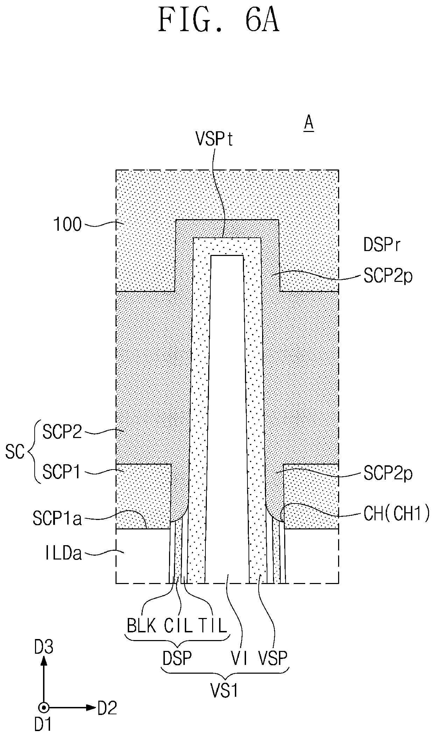

FIG. 6A is an enlarged view of part "A" of FIG. 5D according to some embodiments. For the sake of simplification of the description, the description of the overlapping configuration will be omitted. Referring to FIG. 6A, unlike FIG. 5E, the first vertical channel structure VS1 may not include the lower data storage pattern DSPr, and the protrusion SCP2p may cover an upper surface VSPt of the vertical semiconductor pattern VSP.

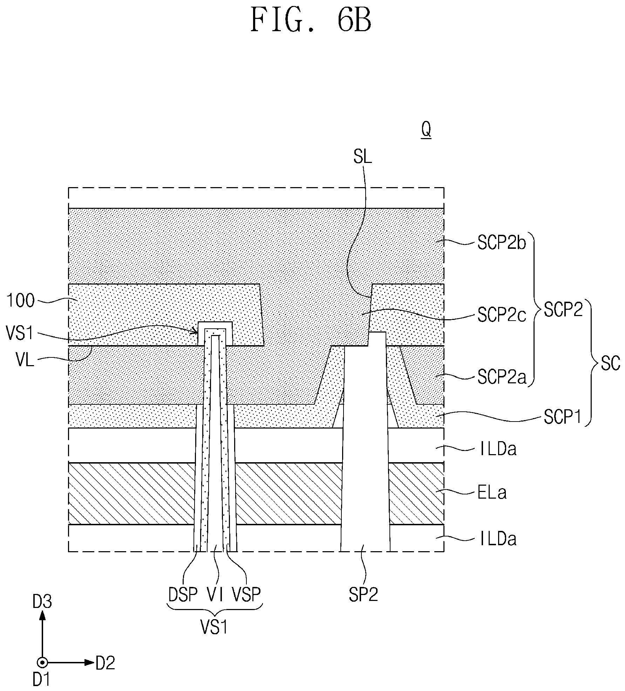

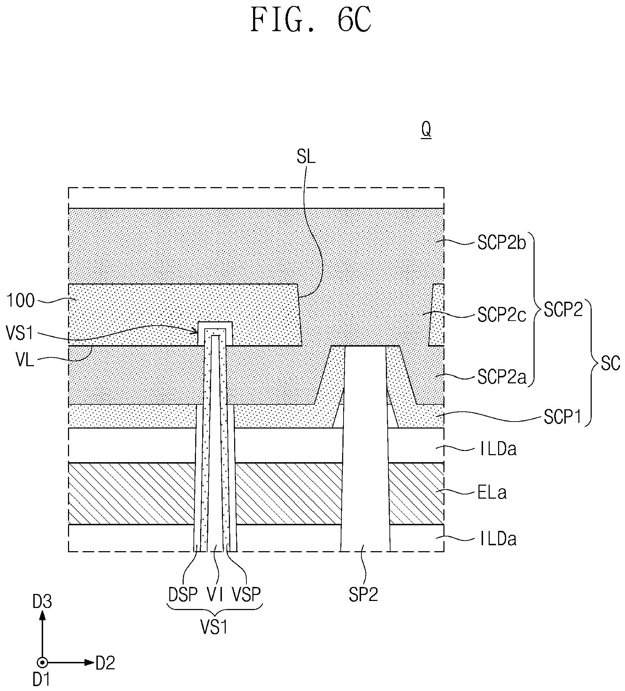

FIGS. 6B and 6C are enlarged views of part "Q" of FIG. 5C according to some embodiments. Referring to FIG. 6B, the slit SL may expose the second separation pattern SP2, and as a result, the source connection part SCP2c may be connected to overlap the second separation pattern SP2. Referring to FIG. 6C, the slit SL may completely expose an upper surface of the second separation pattern SP2. As a result, the first source parts SCP2a on the adjacent stacked structures ST separated with the second separation pattern SP2 therebetween may be commonly connected to one source connection part SCP2c.

FIGS. 7A to 7E are plan views illustrating a source structure SC according to some embodiments of inventive concepts.

Referring to FIG. 7A, a plurality of stacked structures and second separation patterns SP2 therebetween are provided. A plan view of this embodiment may correspond to the embodiment of FIG. 5D. For example, the plurality of stacked structures may include a first stacked structure STa and a second stacked structure STb. One slit SL provided with a source connection part SCP2c may be provided in each of the stacked structures. The source connection part SCP2c may have a line shape or a bar shape substantially parallel to second separation patterns SP2. Unlike the second separation patterns SP2, the source connection part SCP2c may be within a cell array region CAR and may not extend to a cell array contact region EXR.

The source connection part SCP2c may be disposed on one side of the first vertical channel structures VS1 passing through one stacked structure ST. For example, the source connection part SCP2c may be disposed on one side of each of the second separation patterns SP, and may not be disposed on the other side. One first source part SCP2a may be provided in each of the stacked structures. For example, the plurality of first source parts SCP2a may be spaced apart from each other with the second separation patterns SP2 interposed therebetween. One source connection part SCP2c may be provided in each of the stacked structures, like the first source part SCP2a.

The source connection part SCP2c may not overlap the first vertical channel structures VS1. The source connection part SCP2c may be provided between the first vertical channel structure VS1 and the second separation pattern SP2 closest to the second separation pattern SP2 among the first vertical channel structures VS1 passing through the one stacked structure ST. The plurality of first source parts SCP2a may be connected to one second source part SCP2b through the source connection parts SCP2c. For example, the first source part SCP2a (first stacked structure source part) on the first stacked structure STa and the first source part SCP2a on the second stacked structure STb (second stacked structure source part) may be spaced apart from each other, but may be connected to one second source part SCP2b through the source connection parts SCP2c. That is, the second source part SCP2b may cover the plurality of stacked structures.

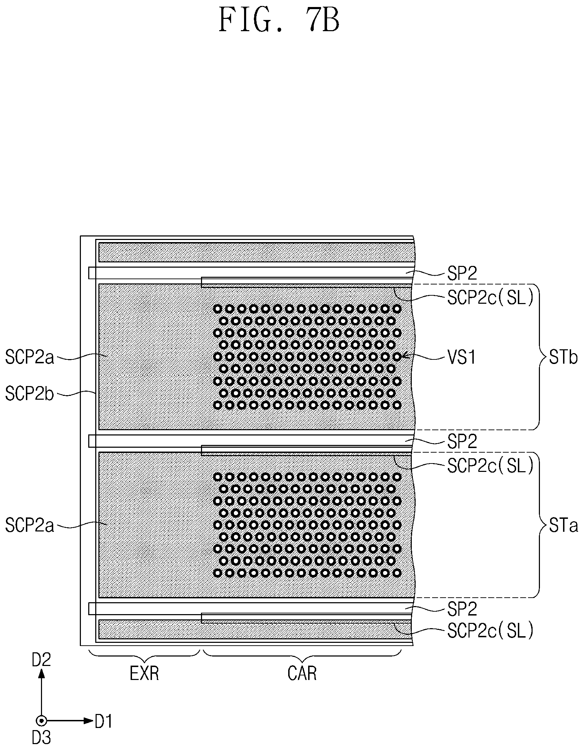

Referring to FIG. 7B, a portion of each of the source connection parts SCP2c may overlap the second separation patterns SP2. A plan view of this embodiment may correspond to the embodiment of FIG. 6B.

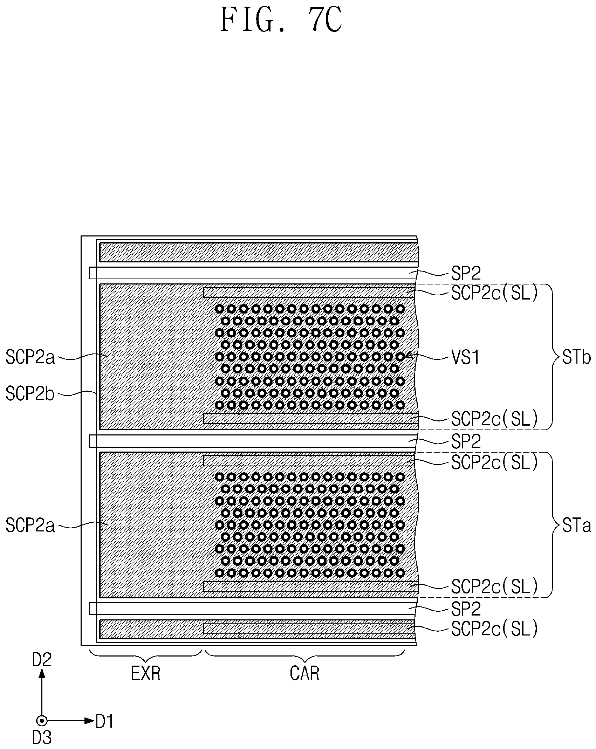

Referring to FIG. 7C, in the present embodiment, a pair of source connection parts SCP2c may be provided in each stacked structure. That is, the source connection parts SCP2c may be provided on both sides of each of the second separation patterns SP.

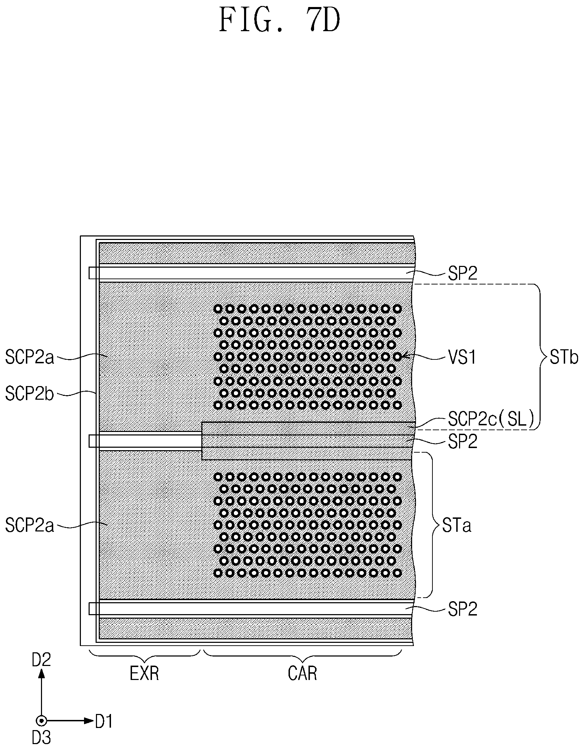

Referring to FIG. 7D, the first source parts SCP2a on the stacked structures adjacent to each other may be connected to the second source part SCP2b through one source connection part SCP2c. That is, a pair of first source parts SCP2a may be connected to one source connection part SCP2c. A plan view of this embodiment may correspond to the embodiment of FIG. 6C. The source connection part SCP2c may be disposed on the even-numbered second separation patterns SP2 among the second separation patterns SP arranged in the second direction D2, and the source connection part SCP2c may not be disposed on the odd-numbered second separation patterns SP2.

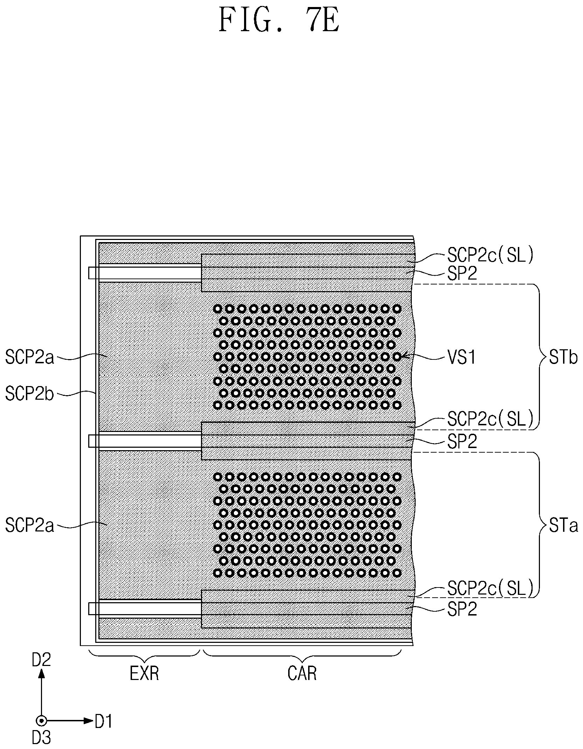

Referring to FIG. 7E, the source connection parts SCP2c may be provided on each of the second separation patterns SP.

According to some embodiments of inventive concepts, the source connection parts SCP2c may be provided in the slits SL passing through the second substrate 100, and the second source part SCP2b and the first source part SCP2a may be provided on upper and lower surfaces of the second substrate 100 connected through the source connection parts SCP2c, respectively. Accordingly, resistance of the source structure SC may be adjusted by adjusting a thickness of the second substrate 100 and/or a thickness of the second source part SCP2b.

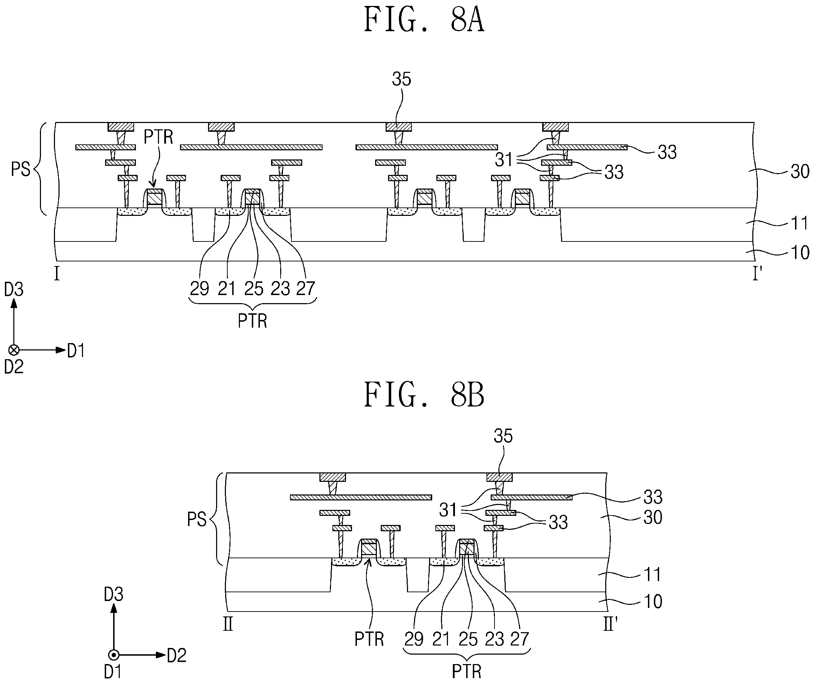

FIGS. 8A and 12A to 15A are cross-sectional views illustrating a method of manufacturing a three-dimensional semiconductor memory device according to some embodiments of inventive concepts and are cross-sectional views taken along line I-I' of FIG. 5A. FIGS. 8B, 12B to 15B are views illustrating a method of manufacturing a three-dimensional semiconductor memory device according to some embodiments of inventive concepts, and are cross-sectional views taken along line II-II' of FIG. 5A.

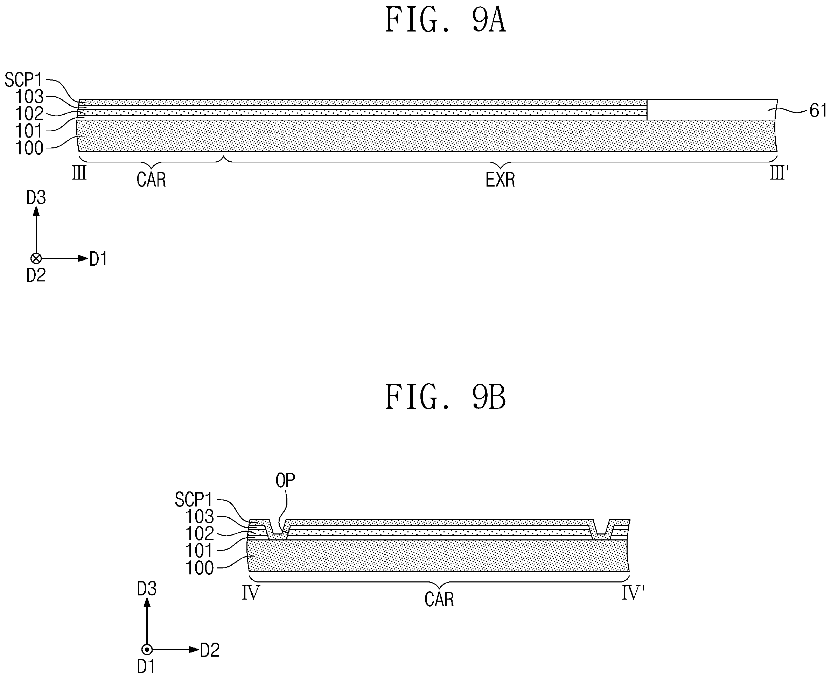

FIGS. 9A to 11A are cross-sectional views illustrating a method of manufacturing a three-dimensional semiconductor memory device according to some embodiments of inventive concepts and are cross-sectional views taken along line III-III' of FIG. 5A. FIGS. 9B to 11B are views illustrating a method of manufacturing a three-dimensional semiconductor memory device according to some embodiments of inventive concepts, and are cross-sectional views taken along line IV-IV' of FIG. 5A.

Referring to FIGS. 5A, 8A and 8B, the peripheral circuit structure PS may be formed on the first substrate 10. Forming the peripheral circuit structure PS may include: forming the device isolation layer 11 in the first substrate 10; forming the peripheral transistors PTR on the active region of the first substrate 10 defined by the device isolation layer 11; forming the peripheral contact plugs 31, the peripheral circuit wirings 33, and the first bonding pads 35 electrically connected to the peripheral transistors PTR; and forming the first interlayer insulating layer 30 covering the peripheral transistors PTR, the peripheral contact plugs 31, the peripheral circuit wirings 33, and the first bonding pads 35.

The upper surfaces of the first bonding pads 35 may be substantially coplanar with the upper surface of the first interlayer insulating layer 30. Hereinafter, substantially coplanar may be provided using a planarization process. The planarization process may be performed, for example, through a chemical mechanical polishing (CMP) process or an etch back process.

Referring to FIGS. 5A, 9A, and 9B, first to third lower sacrificial layers 101, 102, and 103 and the first source conductive pattern SCP1 may be formed on the second substrate 100. The first to third lower sacrificial layers 101, 102, and 103 may be insulating layers. For example, the first and third lower sacrificial layers 101 and 103 may include silicon oxide, and the second lower sacrificial layer 102 may include silicon nitride. Before forming the first source conductive pattern SCP1, lower trenches OP may be formed to pass through the first to third lower sacrificial layers 101, 102, and 103 to expose the second substrate 100. The lower trenches OP may extend in the first direction D1. The first source conductive pattern SCP1 may extend into the lower trenches OP to be in contact with the upper surface of the second substrate 100. The first source conductive pattern SCP1 may be formed of, for example, a semiconductor material doped with impurities. For example, the first source conductive pattern SCP1 may be a polycrystalline silicon layer. After the first to third lower sacrificial layers 101, 102, 103 and the first source conductive pattern SCP1 are patterned, the fifth interlayer insulating layer 61 may be formed on the second substrate 100. The fifth interlayer insulating layer 61 may include silicon oxide. Forming the fifth interlayer insulating layer 61 may include a planarization process.

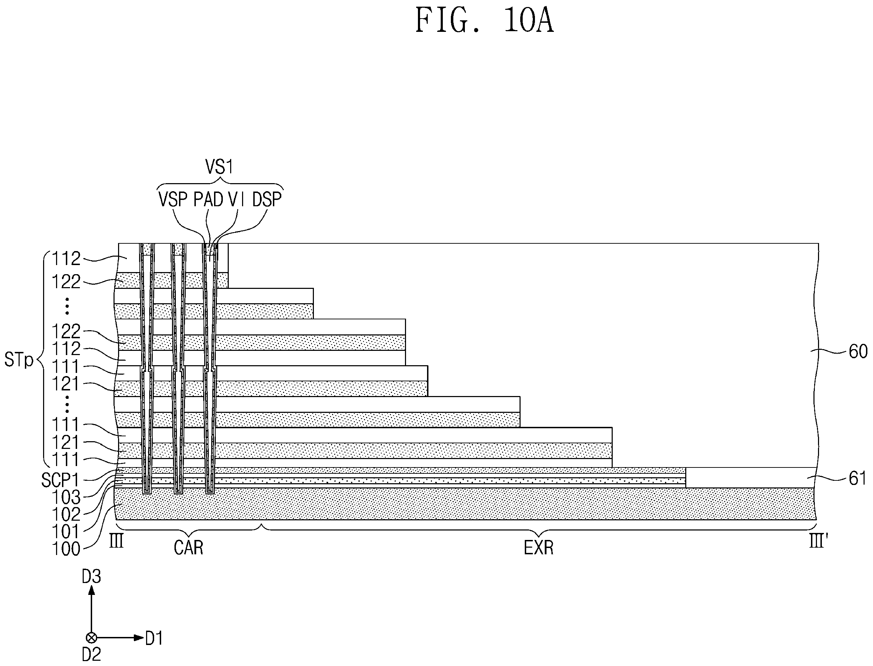

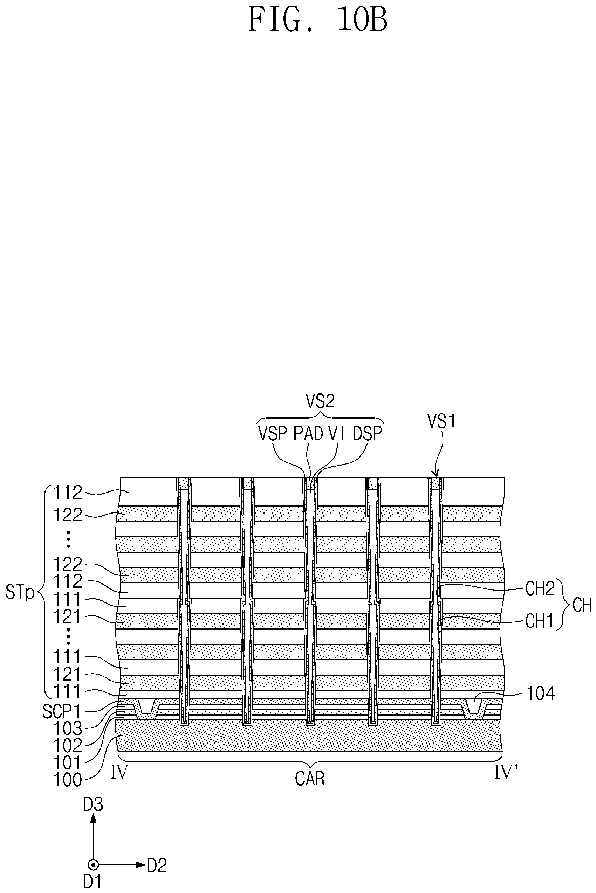

Referring to FIGS. 5A, 10A, and 10B, first interlayer insulating layers 111 and first sacrificial layers 121 may be alternately stacked on the first source conductive pattern SCP1. Thereafter, the first vertical channel holes CH1 passing through the first interlayer insulating layers 111 and the first sacrificial layers 121 may be formed, and sacrificial layers may be filled in the first vertical channel holes CH1. Second interlayer insulating layers 112 and second sacrificial layers 122 may be alternately stacked on the first vertical channel holes CH1. The first and second sacrificial layers 121 and 122 may be formed of an insulating material different from that of the first and second interlayer insulating layers 111 and 112. The first and second sacrificial layers 121 and 122 may be formed of a material that is capable of being etched with etch selectivity with respect to the first and second interlayer insulating layers 111 and 112. For example, the first and second sacrificial layers 121 and 122 may be formed of silicon nitride, and the first and second interlayer insulating layers 111 and 112 may be formed of silicon oxide. Each of the first and second sacrificial layers 121 and 122 may have substantially the same thickness, and the first and second interlayer insulating layers 111 and 112 may have different thicknesses in some regions.

Thereafter, the second vertical channel holes CH2 may be formed through the second interlayer insulating layers 112 and the second sacrificial layers 122 to expose the sacrificial layers in the first vertical channel holes CH1. The second vertical channel holes CH2 may overlap the first vertical channel holes CH1 in the third direction D3 and may be connected to the first vertical channel holes CH1 to form the vertical channel holes CH. After the sacrificial layers exposed by the second vertical channel holes CH2 are removed, the vertical channel structures VS1, VS2, and VS3 may be formed in the vertical channel holes CH. Accordingly, a preliminary stacked structure STp including the first and second interlayer insulating layers 111 and 112 and the first and second sacrificial layers 121 and 122 that are alternately stacked may be formed. Each of the first to third vertical channel structures VS1, VS2, and VS3 may formed by forming the data storage pattern DSP and the vertical semiconductor pattern VSP that conformally cover inner sidewalls of each of the vertical channel holes CH, forming the buried insulating pattern VI in a space surrounded by the vertical semiconductor pattern VSP, and forming the conductive pad PAD in a space surrounded by the buried insulating pattern VI and the data storage pattern DSP. Upper surfaces of the first to third vertical channel structures VS1, VS2, and VS3 may be substantially coplanar with an upper surface of the uppermost one of the second interlayer insulating layers 112 and an upper surface of the fourth interlayer insulating layer 60.

A trimming process may be performed on the preliminary stacked structure STp including the alternately stacked first and second interlayer insulating layers 111 and 112 and the first and second sacrificial layers 121 and 122. The trimming process may include forming a mask pattern covering a portion of the upper surface of the preliminary stacked structure STp in the cell array region CAR and the cell array contact region EXR, patterning the preliminary stacked structure STp through the mask pattern, reducing the area of the mask pattern, and patterning the preliminary stacked structure STp through the mask pattern having the reduced area. Reducing the area of the mask pattern and patterning the preliminary stacked structure STp through the mask pattern may be alternately repeated. At least a portion of each of the first and second interlayer insulating layers 111 and 112 may be exposed to the outside by the trimming process, and a step structure of the preliminary stacked structure STp may be formed in the cell array contact region EXR. The step structure of the preliminary stacked structure STp may expose a portion of the second substrate 100 and the contact pad 193. Thereafter, the fourth interlayer insulating layer 60 covering the step structure of the preliminary stacked structure STp may be formed. For example, the fourth interlayer insulating layer 60 may include silicon oxide.

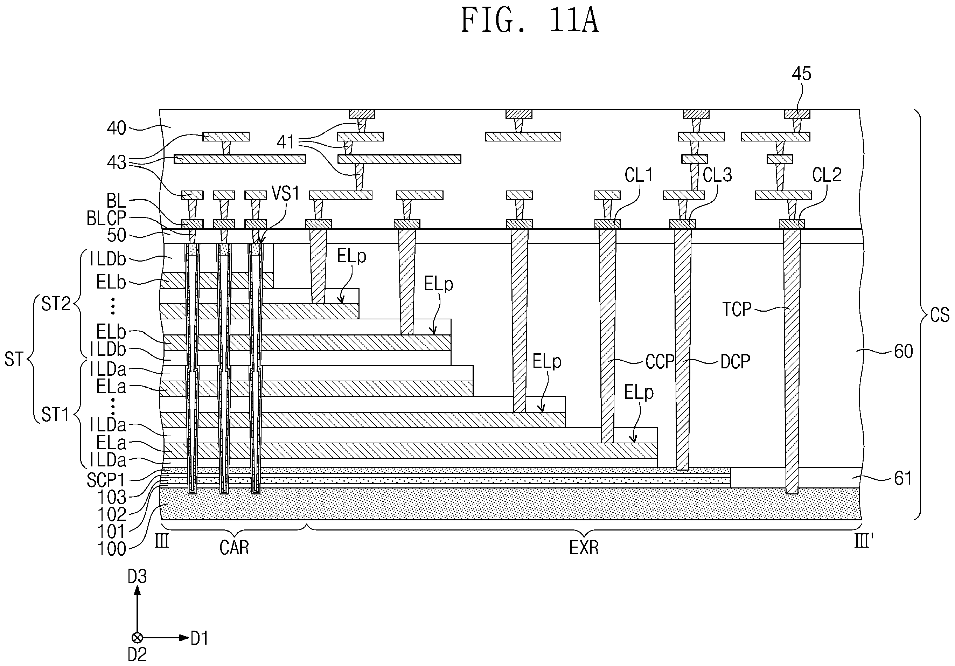

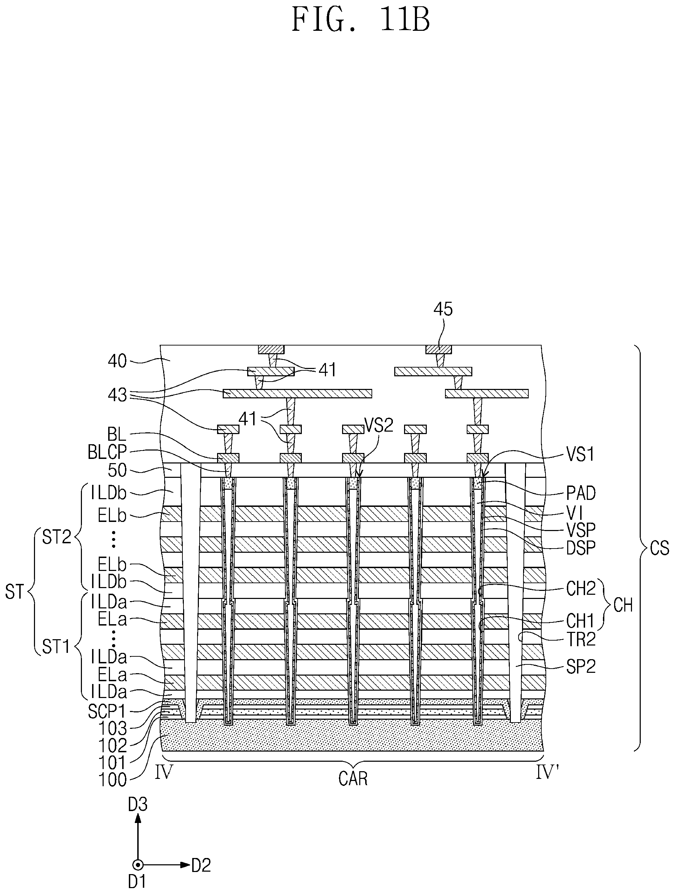

Referring to FIGS. 5A, 11A and 11B, the third interlayer insulating layer 50 covering the upper surface of the fourth interlayer insulating layer 60 may be formed. The second trenches TR2 may be formed passing through at least a portion of the third interlayer insulating layer 50, the preliminary stacked structure STp, the lower semiconductor layer 103, the lower sacrificial layer 101, and the second substrate 100. The first and second sacrificial layers 121 and 122 exposed by the second trenches TR2 may be removed. Removing the first and second sacrificial layers 121 and 122 and the lower sacrificial layer 101 may be performed, for example, using a wet etching process using a hydrofluoric acid (HF) and/or phosphoric acid (H₃PO₄) solution.

The first and second gate electrodes ELa and ELb may be formed to fill a space in which the first and second sacrificial layers 121 and 122 are removed. The first and second interlayer insulating layers 111 and 112 may be referred to as first and second interlayer insulating layers ILDa and ILDb of the upper and lower stacked structures ST1 and ST2, and thus the stacked structure ST including the first and second interlayer insulating layers ILDa and ILDb and first and second gate electrodes ELa and ELb may be formed.

After forming the first trench TR1 passing through at least a portion of the second gate electrodes ELb, the first separation pattern SP1 filling the first trench TR1 and the second separation pattern SP2 filling the second trench TR2 may be formed. Upper surfaces of the first and second separation patterns SP1 and SP2 may be substantially coplanar with the upper surface of the third interlayer insulating layer 50.

The bit line contact plugs BLCP which pass through the third interlayer insulating layer 50 and are in contact with upper surfaces of the first and second vertical channel structures VS1 and VS2 may be formed in the cell array region CAR. The cell contact plugs CCP which pass through the third and fourth insulating layers 50 and 60 and are in contact with the pad parts ELp of the first and second gate electrodes ELa and ELb may be formed in the cell array contact region EXR. The cell contact plugs CCP may pass through at least a portion of the first and second interlayer insulating layers ILDa and ILDb. The source contact plug DCP connected to the first source conductive pattern SCP1 may be formed in the cell array contact region EXR through the third and fourth insulating layers 50 and 60. The through contact plug TCP connected to the second substrate 100 may be formed in the cell array contact region EXR through the third, fourth, and fifth insulating layers 50, 60, and 61.

At least some of the cell contact plugs CCP, the source contact plug DCP, and the through contact plug TCP may be formed together (e.g., at the same time). Forming the cell contact plugs CCP, the source contact plug DCP, and the through contact plug TCP may include an etching process to form high aspect ratio holes passing through the third and fourth insulating layers 50 and 60.

The bit lines BL in contact with the bit line contact plugs BLCP may be formed on the third interlayer insulating layer 50 in the cell array region CAR. The first to third conductive lines CL1, CL2, and CL3 may be formed on the third interlayer insulating layer 50 in the cell array contact region EXR.

The connection contact plugs 41, the connection circuit wirings 43, and the second bonding pads 45 are electrically connected to respective bit lines BL and first and second conductive lines CL1 and CL2. The second interlayer insulating layer 40 may be formed on the third insulating layer 50 covering the connection contact plugs 41, the connection circuit wirings 43, the second bonding pads 45, the bit lines BL, and the first and second conductive lines CL1 and CL2. Upper surfaces of the second bonding pads 45 may be substantially coplanar with an upper surface of the second interlayer insulating layer 40. Accordingly, the cell array structure CS may be formed on the second substrate 100.

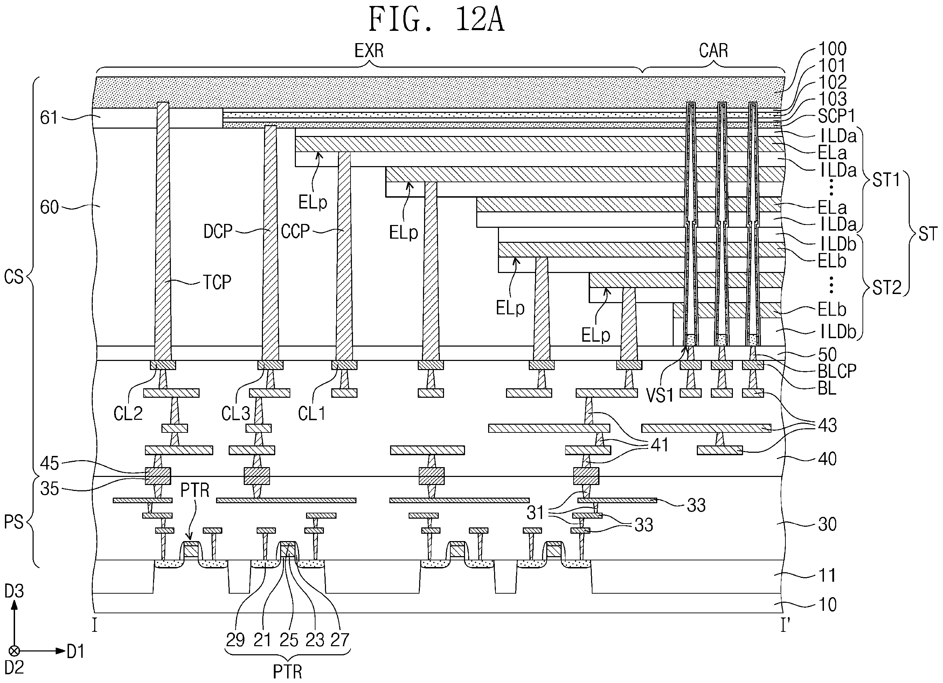

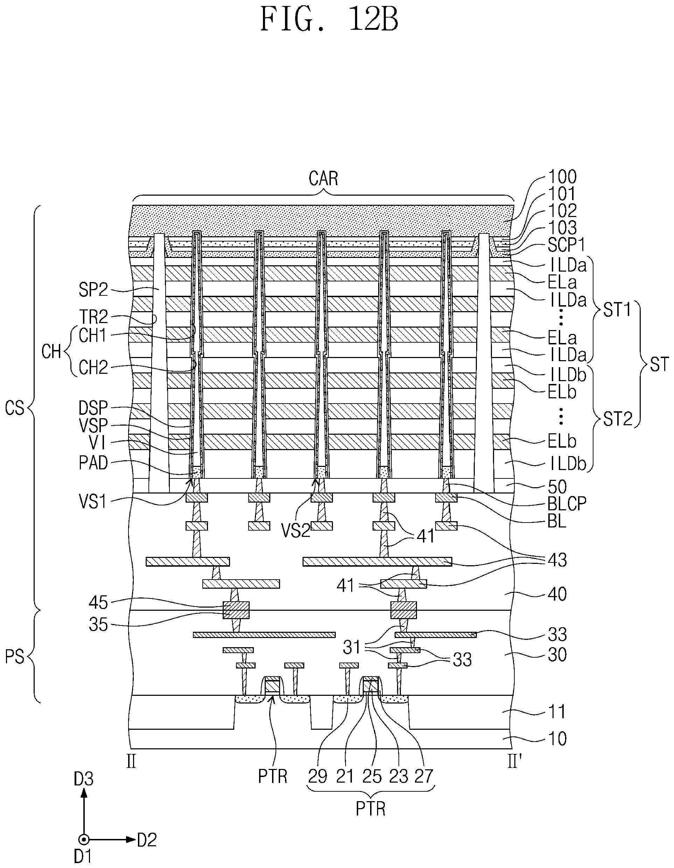

Referring to FIGS. 5A, 12A and 12B, the cell array structure CS formed on the second substrate 100 and the periphery circuit structures PS formed on the first substrate 10 by the method described with reference to FIGS. 8A and 8B may be coupled with each other. In detail, the cell array structure CS may be attached on the peripheral circuit structure PS.

The second substrate 100 may be provided on the first substrate 10 such that the cell array structure CS and the peripheral circuit structure PS face each other. The first bonding pads 35 of the peripheral circuit structure PS may be in contact with the second bonding pads 45 of the cell array structure CS to be fused therebetween.

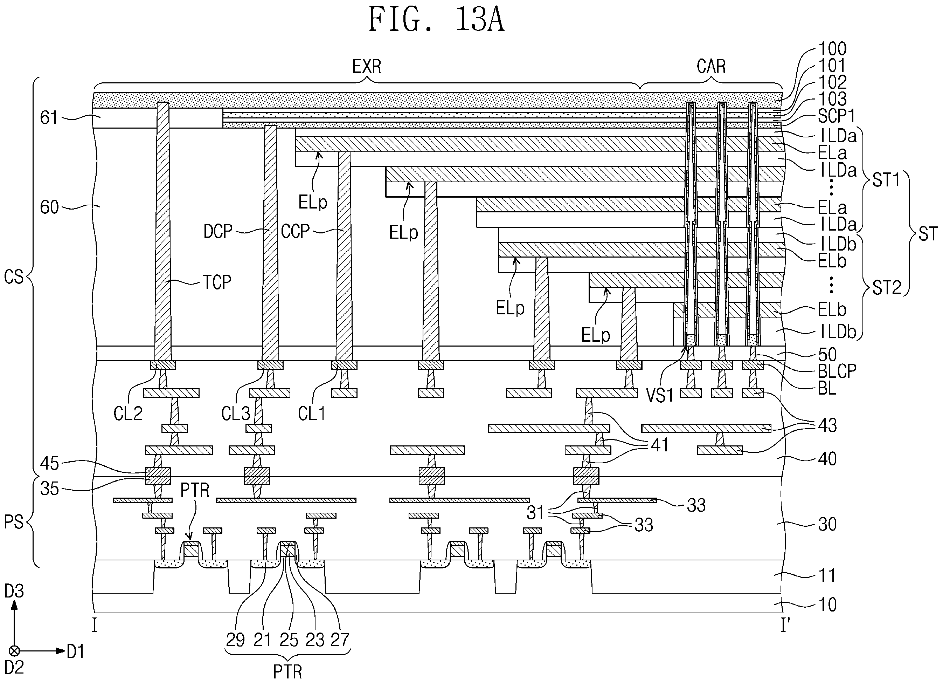

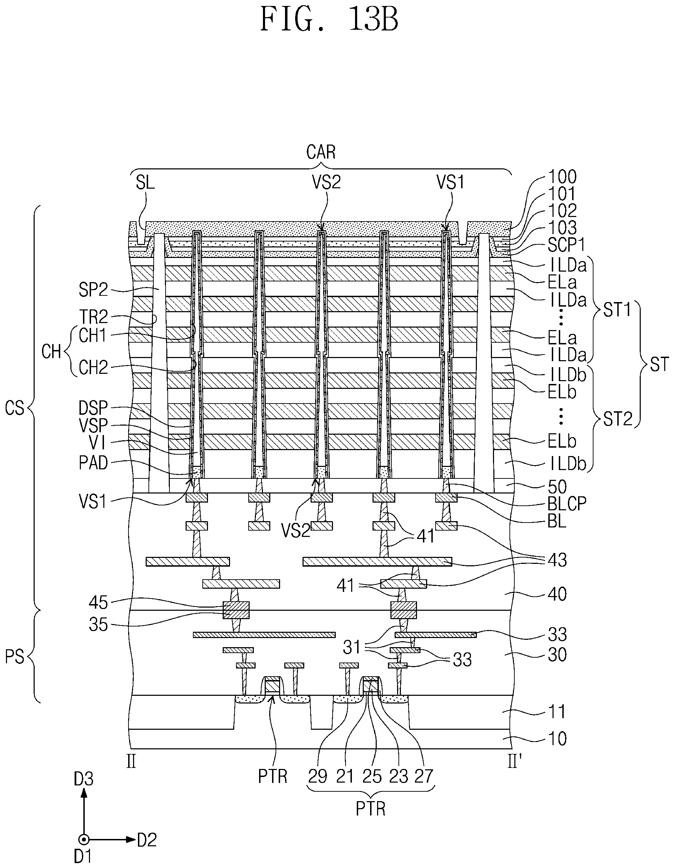

Referring to FIGS. 5A, 13A, and 13B, after the first and second bonding pads 35 and 45 are coupled to each other, an upper portion of the second substrate 100 may be removed. Removing the upper portion of the second substrate 100 may include chemical mechanical polishing. For example, the second substrate 100 from which the upper portion is removed may have a thickness of about 500 nm to about 1500 nm.

The slits SL passing through the second substrate 100 may be formed. Lower surfaces of the slits SL may expose the second lower sacrificial layer 102. Forming the slits SL may include a dry etching process.

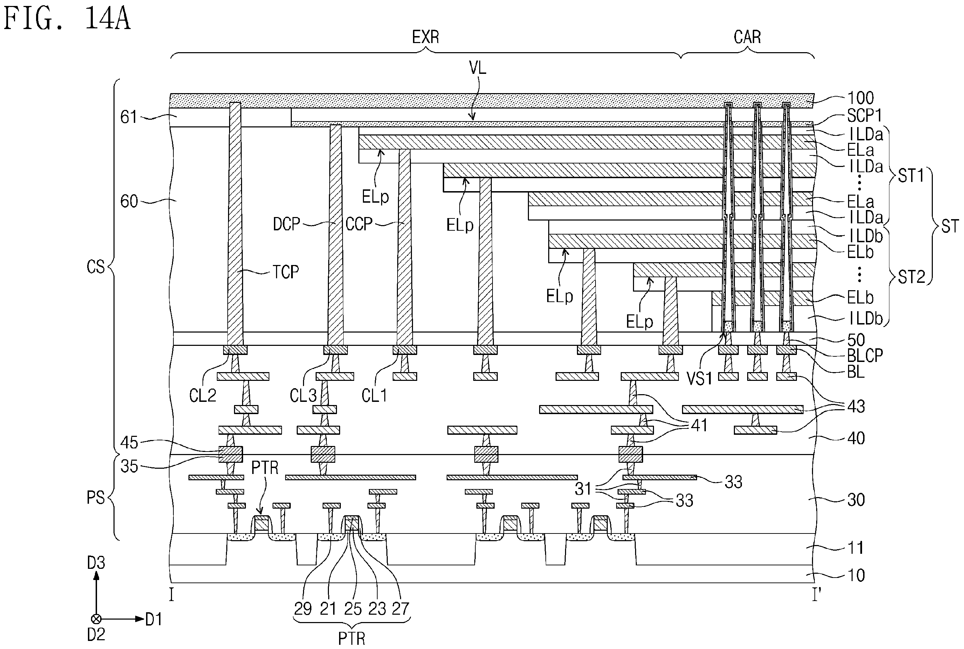

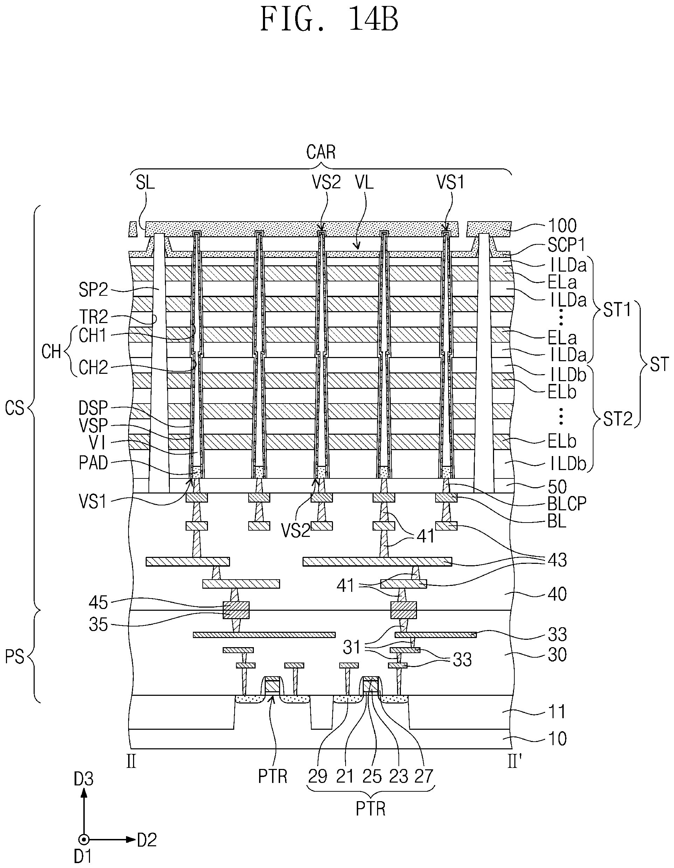

Referring to FIGS. 5A, 14A, and 14B, the first to third lower sacrificial layers 101, 102, and 103 may be removed to form a void region VL. Forming the void region VL may include a first step of removing the second lower sacrificial layer 102 and a second step of removing the first and third lower sacrificial layers 101 and 103. Forming the void region VL may include a selective etching process through the slits SL.

When the void region VL is formed, a portion of the data storage pattern DSP of each of the exposed first and second vertical channel structures VS1 and VS2 may be removed to expose sidewalls of the vertical semiconductor patterns VSP.

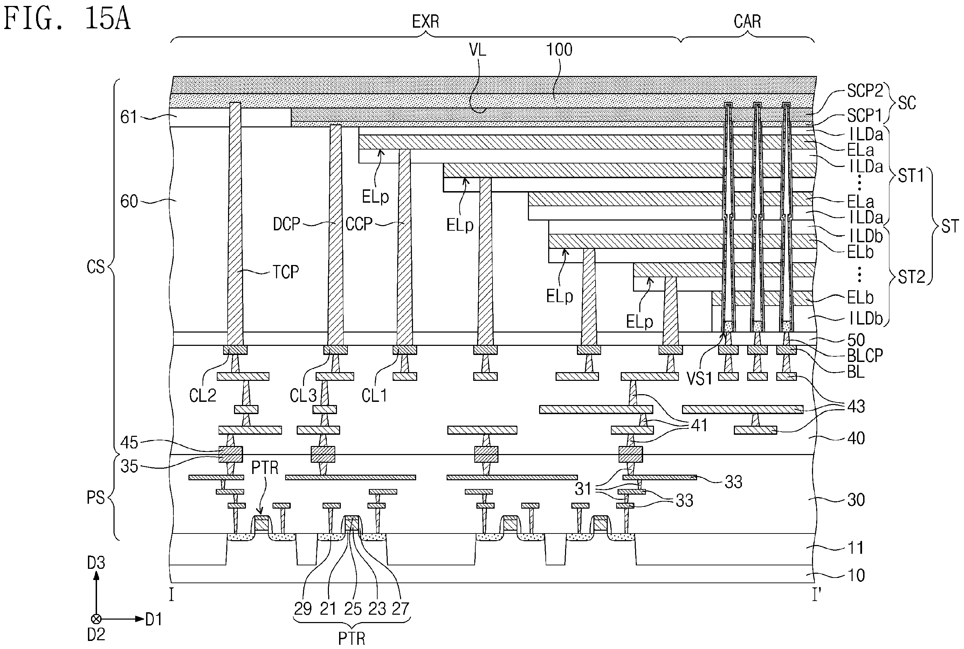

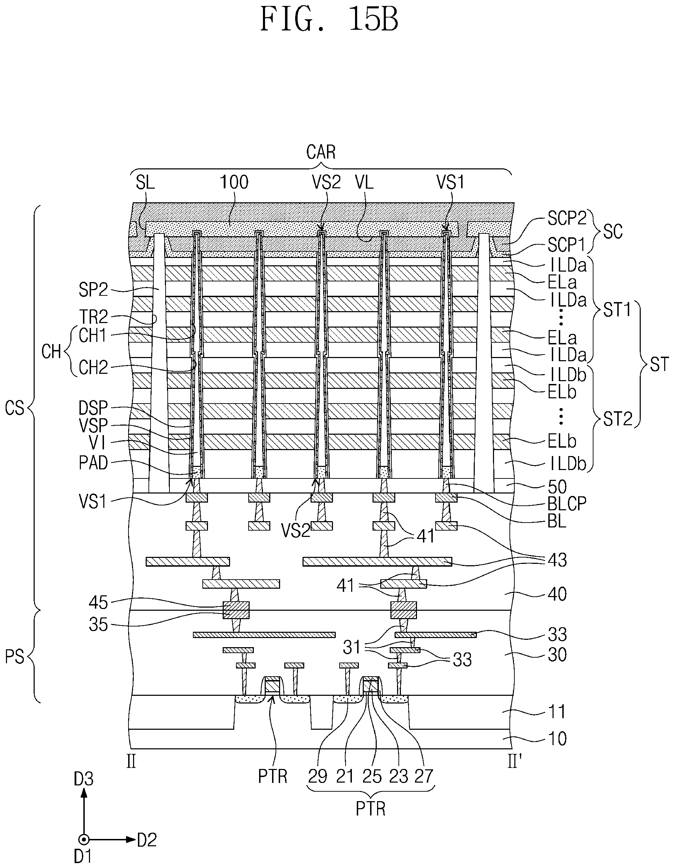

Referring to FIGS. 5A, 15A and 15B, the second source conductive pattern SCP2 may be formed to fill the void region VL and cover the upper surface of the second substrate 100. Forming the second source conductive pattern SCP2 may include a chemical vapor deposition method and/or a selective epitaxial growth method. By a source gas supplied through the slits SL, the first source part SCP2a filling the void region VL may be formed, and then the source connection part SCP2c filling the slits SL may be formed, and thereafter the second source part SCP2b may be formed to cover the upper surface of the second substrate 100 and to be connected to the source connection part SCP2c (refer to FIG. 5D). The second source conductive pattern SCP2 may be a polycrystalline silicon layer or a single crystal silicon layer.

Referring to FIGS. 5A to 5C, the second source part SCP2b and the second substrate 100 may be patterned to form the sixth interlayer insulating layer 181 on the fifth interlayer insulating layer 61. Thereafter, the through via 196 may be formed in the sixth interlayer insulating layer 181. For example, the through via 196 may be formed of at least one of tungsten, titanium, tantalum, and a conductive metal nitride thereof. The back-side conductive pattern 197 connected to the through via 196 may be formed on the sixth interlayer insulating layer 181. The back-side conductive pattern 197 may be formed by forming a metal layer covering the through via 196 and a mask pattern covering the metal layer, and then patterning the metal layer using the mask pattern as an etch mask. As a result, the lower surface of the back-side conductive pattern 197 may be wider than the upper surface thereof. For example, the back-side conductive pattern 197 may be formed of aluminum. Afterwards, the seventh interlayer insulating layer 187 covering the back-side conductive pattern 197 may be formed.

According to some embodiments of inventive concepts, forming the second source part SCP2b may be performed through the slits SL passing through the second substrate 100. Accordingly, the second source part SCP2b may be formed without forming through holes which have a high aspect ratio, pass through the preliminary stacked structure STp, and expose the lower sacrificial layers. Accordingly, the process of manufacturing the semiconductor memory device may be simplified. In addition, it may be possible to reduce and/or prevent an arcing phenomenon capable of occurring when the through-holes having a high aspect ratio are formed, thereby improving electrical characteristics and/or reliability of the semiconductor memory device.

According to some embodiments of inventive concepts, the back-side via and the contact pad used as an etch stop layer may be formed simultaneously, which may reduce and/or prevent arcing that may otherwise occur when forming the high aspect ratio through-holes. Accordingly, it may be possible to simplify the manufacturing process of the semiconductor memory device. In addition, the arcing phenomenon may be reduced and/or prevented by the back-side via and the contact pad, thereby improving the electrical characteristics and reliability of the semiconductor memory device.

While embodiments are described above, a person skilled in the art may understand that many modifications and variations are made without departing from the scope of inventive concepts defined in the following claims. Accordingly, the example embodiments of inventive concepts should be considered in all respects as illustrative and not restrictive, with the scope of inventive concepts being indicated by the appended claims.

## Claims

1. A three-dimensional semiconductor memory device comprising:
a first substrate;
a peripheral circuit structure on the first substrate; and
a cell array structure on the peripheral circuit structure, wherein the cell array structure includes a stacked structure including gate electrodes extending in a first direction, a source structure on the stacked structure, and a second substrate in contact with the source structure,
wherein the source structure includes a first source conductive pattern between the second substrate and the stacked structure, and a second source conductive pattern on the first source conductive pattern, and
wherein the second source conductive pattern includes a first source part between the first source conductive pattern and the second substrate, a source connection part passing through the second substrate and extending in the first direction, and a second source part on the second substrate and connected to the first source part through the source connection part.

2. The three-dimensional semiconductor memory device of claim 1, wherein the cell array structure further includes vertical channel structures connected to the source structure through the stacked structure, the vertical channel structures including vertical semiconductor patterns,
wherein upper portions of the vertical channel structures are provided in a lower portion of the second substrate, and
wherein the vertical semiconductor patterns of the vertical channel structures are electrically connected to the first source part.

3. The three-dimensional semiconductor memory device of claim 1 or 2, wherein a thickness of the second source part is greater than a thickness of the second substrate.

4. The three-dimensional semiconductor memory device of any preceding claim, wherein a thickness of the second source part is greater than a thickness of the first source part.

5. The three-dimensional semiconductor memory device of any preceding claim, wherein the stacked structure includes a first stacked structure and a second stacked structure,
wherein the cell array structure further includes a separation pattern between the first stacked structure and the second stacked structure and extending in the first direction, and
wherein the source connection part has a line shape substantially parallel to the separation pattern.

6. The three-dimensional semiconductor memory device of claim 5, wherein the source connection part comprises a first source connection part on the first stacked structure and a second source connection part on the second stacked structure.

7. The three-dimensional semiconductor memory device of claim 6,
wherein the first source part includes a first stacked structure source part between the first source connection part and the first stacked structure, and a second stacked structure source part between the second source connection part and the second stacked structure, and
wherein the first stacked structure source part and the second stacked structure source part are spaced apart from each other in a second direction intersecting the first direction with the separation pattern therebetween.

8. The three-dimensional semiconductor memory device of claim 7, wherein the second source part is electrically connected to the first stacked structure source part and the second stacked structure source part.

9. The three-dimensional semiconductor memory device of any of claims 5 to 8, wherein the cell array structure further includes vertical channel structures connected to the source structure through the stacked structure, and
wherein the source connection part is between the separation pattern and a vertical channel structure that is closest to the separation pattern among the vertical channel structures.

10. The three-dimensional semiconductor memory device of any of claims 5 to 9, wherein, in a plan view, the source connection part overlaps at least a portion of the separation pattern.

11. The three-dimensional semiconductor memory device of any preceding claim, wherein the first source part, the source connection part, and the second source part include the same material.

12. The three-dimensional semiconductor memory device of any preceding claim, wherein the cell array structure includes a cell array region and a cell array contact region on one side of the cell array region, and
wherein the source connection part is within the cell array region.
